# EUROPEAN PATENT APPLICATION

(11) **EP 4 822 990 A1**
(43) Date of publication of application: **14.10.2026**
(21) Application number: 26171173.3
(22) Date of filing: 08.04.2026
(51) Int. Cl.: H03K 17/082, H02H 3/08, H03K 17/12, H03K 17/0814

(54) **BREAKING CURRENT CONTROL IN SOLID-STATE CIRCUIT BREAKERS**

(30) Priority: 11.04.2025 US 202519176851
(71) Applicant: Rockwell Automation Technologies, Inc., Mayfield Heights, OH 44124 (US)
(72) Inventor: Adkins, Kyle B., Mayfield Heights, OH 44124 (US); Carlson, Andrew E., Mayfield Heights, OH 44124 (US); Brickner, James E., Mayfield Heights, OH 44124 (US)
(74) Representative: Grünecker Patent- und Rechtsanwälte PartG mbB

(57) **Abstract**

The present technology relates to clamping breaking currents in a circuit breaker to protect solid-state switches of the circuit breaker during an overload event. **In** an embodiment, a circuit breaker includes processing circuitry and switching circuitry coupled to the processing circuitry. The switching circuitry includes a first switch coupled to an AC voltage supply, a second switch, and the processing circuitry, a second switch coupled to the first switch, a load, and the processing circuitry, a first current clamping circuit coupled to the AC voltage supply, the second switch, and the processing circuitry, and a second current clamping circuit coupled to the AC voltage supply the first switch, and the processing circuitry. The processing circuitry monitors current at the load and provides gating signals to the first and second switches and the first and second current clamping circuits to control current flow between the AC voltage supply and the load.

## Description

### TECHNICAL FIELD

Various embodiments of the present technology relate to solid-state circuit breakers, and particularly, to controlling breaking currents in solid-state circuit breakers.

### BACKGROUND

Circuit breakers are electrical switching devices designed to protect electrical circuits from potential damage that can be caused by short circuits or overloads. Circuit breakers are implemented in industrial environments as components of electrical circuits to allow current flow through the circuit in one mode and prevent current flow through the circuit in another mode. An example type of circuit breaker is a solid-state circuit breaker. Solid-state circuit breakers may include both physical switches (e.g., mechanical contacts) and solid-state switching devices (e.g., transistors) to transition between modes (e.g., on, off, standby, tripped).

In an on mode, an electrical connection is created by closing switches of the circuit breaker allowing current flow from a power source to a load. If an overload condition occurs while operating in the on mode, such as a short circuit, the switches are opened to interrupt the current flow in the circuit preventing potential damage to the power supply, the load, humans, and other devices in the industrial environment. The switches of the circuit breaker must open quickly to thermally protect themselves. Problematically, breaking current flow through the circuit breaker nearly-instantaneously generates large voltage transients within the circuit breaker due to the inductance of the load. These voltage transients must also be managed to protect the switches from damage.

In existing solutions, circuit breakers include devices, such as metal-oxide varistors (MOVs) or transient voltage suppression (TVS) diodes, to dissipate voltage spikes caused when a circuit breaker trips, and current flow is broken through the circuit breaker. However, these devices tend to have higher clamping voltages and limited energy ratings, which might not mitigate damage to the switches. As a result, such solutions may also include solid-state switches with higher voltage ratings than would be required for the application itself to offset limitations of the voltage transient dissipation devices. This may increase the cost and the size of the circuit breaker and reduce thermal performance of the switches.

It is with respect to this general technical environment that aspects of the present disclosure have been contemplated. Furthermore, although a general environment is discussed, it should be understood that the examples described should not be limited to the general environment identified in the background.

### SUMMARY

Various embodiments of the present technology generally relate to improvements to industrial circuit breakers. More specifically, systems, devices, and methods are disclosed for dissipating voltage transients within a circuit breaker by routing current flow of breaking currents through current clamping circuits to protect switches of the circuit breaker. In an embodiment of the present technology, a circuit breaker is provided that includes processing circuitry and switching circuitry coupled to the processing circuitry. The switching circuitry includes a first switch including a first terminal coupled to an alternating current (AC) voltage supply, a second terminal, and a control terminal coupled to the processing circuitry, a second switch including a first terminal coupled to the second terminal of the first switch, a second terminal coupled to a load, and a control terminal coupled to the processing circuitry, a first current clamping circuit including an input terminal coupled to the AC voltage supply, a control terminal coupled to the processing circuitry, and an output terminal coupled to the first terminal of the second switch, and a second current clamping circuit including an input terminal coupled to the load, a control terminal coupled to the processing circuitry, and an output terminal coupled to the second terminal of the first switch. The processing circuitry is configured to monitor the current at the load and provide gating signals to the control terminals of the first switch, the second switch, the first current clamping circuit, and the second current clamping circuit to control a path of current flow between the AC voltage supply and the load based at least in part on the current at the load.

In another embodiment, a method of operating a circuit breaker is provided. The method includes monitoring a current of a load coupled to a circuit breaker. The circuit breaker includes a first switch including a first terminal coupled to an alternating current (AC) voltage supply, a second terminal, and a control terminal coupled to the processing circuitry, a second switch including a first terminal coupled to the second terminal of the first switch, a second terminal coupled to the load, and a control terminal coupled to the processing circuitry, a first current clamping circuit including an input terminal coupled to the AC voltage supply, a control terminal coupled to the processing circuitry, and an output terminal coupled to the first terminal of the second switch, and a second current clamping circuit including an input terminal coupled to the load, a control terminal coupled to the processing circuitry, and an output terminal coupled to the second terminal of the first switch. The method also includes, responsive to determining that the current at the load has reached a threshold breaking current, transmitting gating signals to the control terminals of the first switch, the second switch, the first current clamping circuit, and the second current clamping circuit to control a path of current flow between the AC voltage supply and the load based at least in part on the current at the load.

In yet another embodiment, a circuit breaker is provided that includes processing circuitry and switching circuitry coupled to the processing circuitry. The switching circuitry includes a first switch including a first terminal coupled to an alternating current (AC) voltage supply, a second terminal, and a control terminal coupled to the processing circuitry, a first thyristor including an anode terminal coupled to the second terminal of the first switch, and a cathode terminal coupled to the first terminal of the first switch, a second switch including a first terminal coupled to the second terminal of the first switch, a second terminal coupled to a load, and a control terminal coupled to the processing circuitry, a second thyristor including an anode terminal coupled to the second terminal of the second switch, and a cathode terminal coupled to the first terminal of the second switch, a first current clamping circuit including an input terminal coupled to the AC voltage supply, a control terminal coupled to the processing circuitry, and an output terminal coupled to the first terminal of the second switch, and a second current clamping circuit including an input terminal coupled to the load, a control terminal coupled to the processing circuitry, and an output terminal coupled to the second terminal of the first switch. The processing circuitry is configured to monitor the current at the load and provide gating signals to the control terminals of the first switch, the second switch, the first current clamping circuit, and the second current clamping circuit to control a path of current flow between the AC voltage supply and the load based at least in part on the current at the load.

This Summary is provided to introduce a selection of concepts in a simplified form that are further described below in the Detailed Description. This Summary is not intended to identify key features or essential features of the claimed subject matter, nor is it intended to be used as an aid in determining the scope of the claimed subject matter.

While multiple embodiments are disclosed, still other embodiments of the present technology will become apparent to those skilled in the art from the following detailed description, which shows and describes illustrative embodiments of the invention. As will be realized, the technology is capable of modifications in various aspects, all without departing from the scope of the present invention. Accordingly, the drawings and detailed description are to be regarded as illustrative in nature and not restrictive.

### BRIEF DESCRIPTION OF THE DRAWINGS

Many aspects of the disclosure can be better understood with reference to the following drawings. The components in the drawings are not necessarily drawn to scale. Moreover, in the drawings, like reference numerals designate corresponding parts throughout the several views. While several embodiments are described in connection with these drawings, the disclosure is not limited to the embodiments disclosed herein. On the contrary, the intent is to cover all alternatives, modifications, and equivalents.
Figure 1 illustrates an example operating environment in accordance with some embodiments of the present technology.
Figure 2 illustrates an example operating environment in accordance with some embodiments of the present technology.
Figure 3 illustrates an example method for operating switching circuitry of a circuit breaker in accordance with some embodiments of the present technology.
Figures 4A, 4B, 4C, and 4D illustrate example aspects of switching circuitry of a circuit breaker and resulting current flow through the elements of the switching circuitry during operation in accordance with some embodiments of the present technology.
Figure 5 illustrates example graphical representations related to switching operations of a circuit breaker in accordance with some embodiments of the present technology.
Figure 6 illustrates example graphical representations related to switching operations of a circuit breaker in accordance with some embodiments of the present technology.
Figure 7 illustrates example graphical representations related to switching operations of a circuit breaker in accordance with some embodiments of the present technology.
Figure 8 illustrates an example operating environment in accordance with some embodiments of the present technology.
Figures 9A and 9B illustrate example aspects of switching circuitry of a circuit breaker and resulting current flow through the elements of the switching circuitry during operation in accordance with some embodiments of the present technology.
Figure 10 illustrates an example operating environment in accordance with some embodiments of the present technology.
Figure 11 illustrates an example computing system used in some embodiments of the present technology.

The drawings have not necessarily been drawn to scale. Similarly, some components or operations may not be separated into different blocks or combined into a single block for the purposes of discussion of some of the embodiments of the present technology. Moreover, while the technology is amendable to various modifications and alternative forms, specific embodiments have been shown by way of example in the drawings and are described in detail below. The intention, however, is not to limit the technology to the particular embodiments described. On the contrary, the technology is intended to cover all modifications, equivalents, and alternatives falling within the scope of the technology as defined by the appended claims.

### DETAILED DESCRIPTION

Technology is disclosed herein that mitigates the problems discussed above with respect to industrial circuit breakers and associated voltage transients while an operational circuit breaker trips and breaks current flow between a power source and a load.

A circuit breaker is a switching device that interrupts current flow during fault conditions or overload situations, thereby preventing damage caused by overcurrent. In industrial or commercial environments, circuit breakers are used to protect various electrical systems and devices while the systems and devices perform industrial automation operations. For example, a circuit breaker may be included in a circuit of a system powered by an alternating current (AC) power source (e.g., AC mains) or a direct current (DC) power source. The recipient of the power is referred to as the load. In operation, the circuit breaker can be turned on to allow current flow from the power source through the circuit breaker to the load allowing the system to receive power and perform respective functions. The circuit breaker can also be turned off to prevent current flow and protect the system from potential damage that can be caused by short circuits or overloads.

One type of circuit breaker is a solid-state circuit breaker. Solid-state circuit breakers utilize solid-state switching components (e.g., transistors) to allow and prevent current flow offering a more robust and cheaper alternative compared to electromechanical circuit breakers. The solid-state switching components can be turned on (i.e., the switching components function as closed switches) and off (i.e., the switching components function as open switches) based on signals provided to the switching components by a processing device. These signals and resulting mode transitions occur almost instantaneously allowing operation of a circuit breaker to safely connect and disconnect power supplies from loads. For example, the solid-state switching components can be turned off quickly upon detection of a fault condition, which can prevent damage to the switching components themselves, the power source, and the load.

When a solid-state circuit breaker is turned off while current flows through the circuit breaker (i.e., the circuit breaker is on, then turned off upon detection of a fault condition), a large spike in voltage, or a voltage transient, is generated within the circuit breaker due to the load inductance. Because current produced by the voltage transient cannot flow to the load or the power source when the circuit breaker is turned off, the voltage transient can cause current to flow to the solid-state switching components, thereby potentially damaging the solid-state switching components if the voltage transient exceeds their voltage rating and thereby limiting the life of the solid-state switching components.

In existing solutions, metal-oxide varistors (MOVs) or transient voltage suppression (TVS) diodes are included in solid-state circuit breakers to mitigate such issues caused when a circuit breaker trips, and current flow is broken through the circuit breaker. However, these devices tend to have higher clamping voltages and limited energy ratings, which might not effectively mitigate damage to the solid-state switches unless solid-state switches with high voltage ratings are included in the circuit breaker, which may be costly with respect to size and price.

To address these issues, a circuit breaker is described herein that includes multiple current clamping circuits for dissipating energy of a voltage transient and breaking current of the voltage transient. More specifically, in AC power applications, the circuit breaker includes three sub-circuits each corresponding to a phase of three-phase AC power supplied to the circuit breaker by an AC power source. Each sub-circuit is coupled to one phase terminal of the AC power source and to a respective phase terminal of the load. Each sub-circuit includes two solid-state switches and two current clamping circuits. Each current clamping circuit is coupled in parallel with a respective one of the solid-state switches. During operation when the circuit breaker is turned off due to detection of a fault condition, current flow is routed through a current clamping circuit and a switch not coupled in parallel with the given current clamping circuit, thereby advantageously reducing the current flow through the switch coupled in parallel with the given current clamping circuit and preventing damage thereto. In DC power applications, the circuit breaker includes a single solid-state switch and a current clamping circuit in parallel with the solid-state switch, which can be similarly operated to route current flow through the current clamping circuit as opposed to the solid-state switch.

In an embodiment of the present technology, a circuit breaker is provided that includes processing circuitry and switching circuitry coupled to the processing circuitry. The switching circuitry includes a first switch including a first terminal coupled to an alternating current (AC) voltage supply, a second terminal, and a control terminal coupled to the processing circuitry, a second switch including a first terminal coupled to the second terminal of the first switch, a second terminal coupled to a load, and a control terminal coupled to the processing circuitry, a first current clamping circuit including an input terminal coupled to the AC voltage supply, a control terminal coupled to the processing circuitry, and an output terminal coupled to the first terminal of the second switch, and a second current clamping circuit including an input terminal coupled to the load, a control terminal coupled to the processing circuitry, and an output terminal coupled to the second terminal of the first switch. The processing circuitry is configured to monitor the current at the load and provide gating signals to the control terminals of the first switch, the second switch, the first current clamping circuit, and the second current clamping circuit to control a path of current flow between the AC voltage supply and the load based at least in part on the current at the load.

In another embodiment, a method of operating a circuit breaker is provided. The method includes monitoring a current of a load coupled to a circuit breaker. The circuit breaker includes a first switch including a first terminal coupled to an alternating current (AC) voltage supply, a second terminal, and a control terminal coupled to the processing circuitry, a second switch including a first terminal coupled to the second terminal of the first switch, a second terminal coupled to the load, and a control terminal coupled to the processing circuitry, a first current clamping circuit including an input terminal coupled to the AC voltage supply, a control terminal coupled to the processing circuitry, and an output terminal coupled to the first terminal of the second switch, and a second current clamping circuit including an input terminal coupled to the load, a control terminal coupled to the processing circuitry, and an output terminal coupled to the second terminal of the first switch. The method also includes, responsive to determining that the current at the load has reached a threshold breaking current, transmitting gating signals to the control terminals of the first switch, the second switch, the first current clamping circuit, and the second current clamping circuit to control a path of current flow between the AC voltage supply and the load based at least in part on the current at the load.

In yet another embodiment, a circuit breaker is provided that includes processing circuitry and switching circuitry coupled to the processing circuitry. The switching circuitry includes a first switch including a first terminal coupled to an alternating current (AC) voltage supply, a second terminal, and a control terminal coupled to the processing circuitry, a first thyristor including an anode terminal coupled to the second terminal of the first switch, and a cathode terminal coupled to the first terminal of the first switch, a second switch including a first terminal coupled to the second terminal of the first switch, a second terminal coupled to a load, and a control terminal coupled to the processing circuitry, a second thyristor including an anode terminal coupled to the second terminal of the second switch, and a cathode terminal coupled to the first terminal of the second switch, a first current clamping circuit including an input terminal coupled to the AC voltage supply, a control terminal coupled to the processing circuitry, and an output terminal coupled to the first terminal of the second switch, and a second current clamping circuit including an input terminal coupled to the load, a control terminal coupled to the processing circuitry, and an output terminal coupled to the second terminal of the first switch. The processing circuitry is configured to monitor the current at the load and provide gating signals to the control terminals of the first switch, the second switch, the first current clamping circuit, and the second current clamping circuit to control a path of current flow between the AC voltage supply and the load based at least in part on the current at the load.

Advantageously, the disclosed circuit breaker, and corresponding methods of operation, can effectively break currents caused by voltage transients, thereby preventing damage to solid-state switches without using solid-state switches having voltage ratings that exceed the application requirements and without using clamping components that require voltage de-rating, such as MOVs, both of which may improve thermal performance of circuit breaker, decrease the product size and cost, and reduce the need for heat-sinking within the circuit breaker. In AC power applications, the disclosed circuit breaker can operate bidirectionally thus dissipating energy from a voltage transient in multiple directions and preventing damage to multiple solid-state switches.

While many of the embodiments described herein relate to circuit breakers and specific components thereof, the current breaking and voltage transient energy dissipation techniques may be applicable to various other devices and circuits operable in three-phase power applications, DC power applications, and to circuit breakers and other such devices having different types of solid-state switching elements.

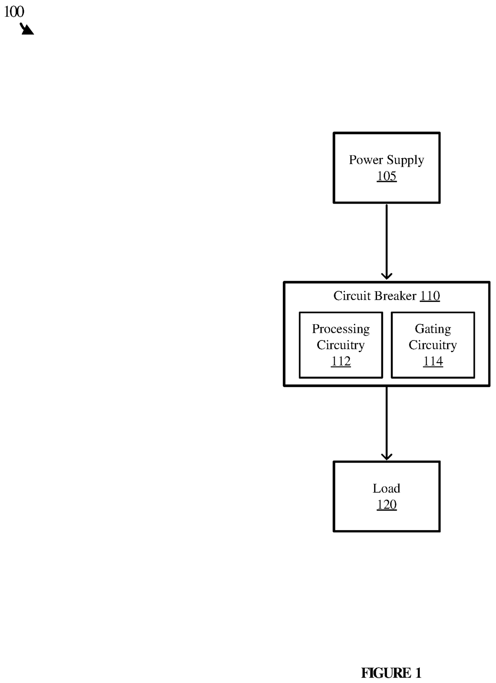

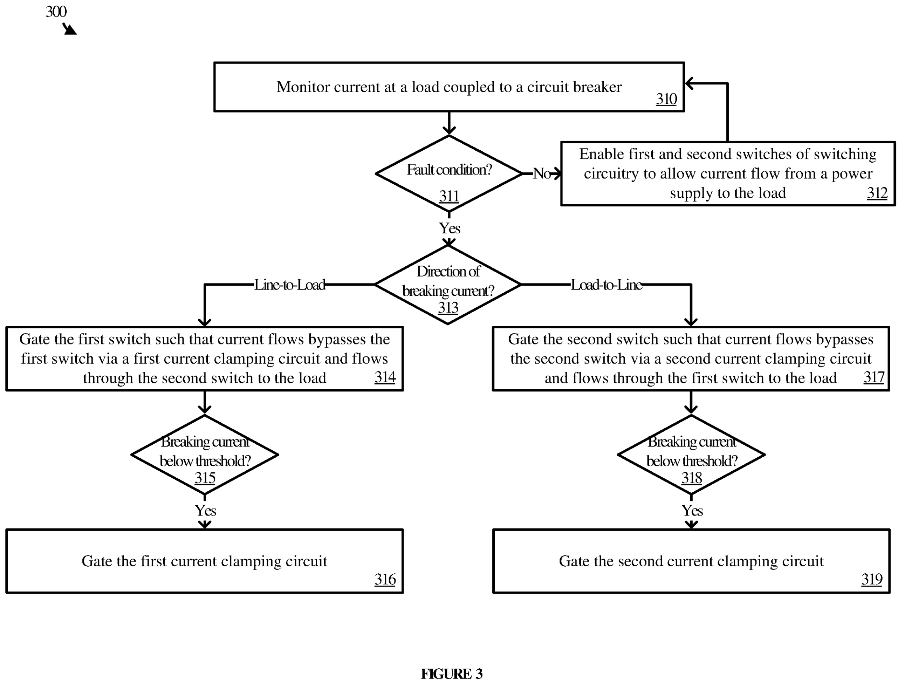

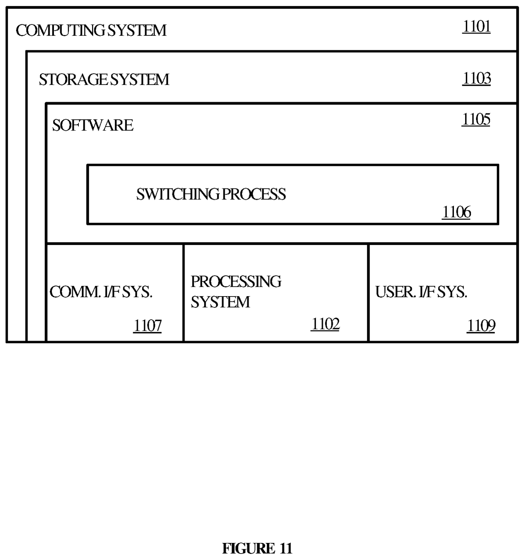

Moving now to the Figures, **Figure 1** illustrates an example operating environment in accordance with some embodiments of the present technology. Figure 1 includes operating environment 100, which is representative of an environment in which industrial and commercial processes may be performed. Operating environment 100 includes power supply 105, circuit breaker 110, and load 120. Circuit breaker 110 includes processing circuitry 112 and switching circuitry 114, which both include additional elements omitted from Figure 1 for the sake of simplicity. Examples of switching circuitry 114 are shown and described in Figures 3, 8, and 10 below. An example of processing circuitry 112 is shown and described in Figure 11 below.

In operating environment 100, power supply 105 is representative of a power source capable of providing power to load 120 via circuit breaker 110. In some embodiments, power supply 105 is a direct current (DC) power supply. In some embodiments, power supply 105 is an alternating current (AC) power supply. For example, power supply 105 is representative of AC mains electricity capable of producing power categorized under Class 1 or Class 2 power of the National Electrical Code (NEC). Power supply 105 is coupled to circuit breaker 110 and provides power to load 120 via circuit breaker 110. More specifically, in AC applications, power supply 105 includes three phase-terminals coupled to three terminals of circuit breaker 110. Each phase-terminal corresponds to a phase of three-phase AC power produced by power supply 105.

Load 120 is representative of a system or device operating in an industrial, commercial, industrial automation, or similar environment. For example, load 120 includes a motor, a drive, a circuit, or any other industrial, commercial, or electrical device, as well as combinations and variations thereof. In AC applications, load 120 includes three input terminals (also referred to as phase terminals) coupled to three output terminals of circuit breaker 110. Each of the input terminals of load 120 corresponds to a phase of three-phase AC power supplied to load 120 by power supply 105 via circuit breaker 110.

Circuit breaker 110 is representative of a solid-state circuit breaker capable of receiving power from power supply 105 and providing the power to load 120 to enable operations of load 120. To do so, circuit breaker 110 includes switching circuitry 114, and processing circuitry 112, which may control elements of switching circuitry 114 to allow current flow from power supply 105 to load 120 at certain times and prevent current flow from power supply 105 to load 120 at other times.

Processing circuitry 112 is representative of one or more processors, processing cores, or processing circuits capable of interfacing with power supply 105 to receive power from power supply 105, monitoring the current and voltage of power supply 105, monitoring the current and voltage within circuit breaker 110, monitoring the current and voltage to load 120, and transmitting signals to switching circuitry 114 to control states of components of switching circuitry 114, and thereby, controlling current flow through switching circuitry 114. Processing circuitry 112 may generate and output the signals based on the voltage/current from power supply 105 and/or the voltage/current within circuit breaker 110. Examples of such processor(s) of processing circuitry 112 include - but are not limited to - microcontrollers, microprocessors, general purpose processing units, central processing units (CPUs), graphical processing units (GPUs), digital signal processors (DSPs), application specific processors or circuits (e.g., ASICs), and logic devices (e.g., FPGAs), as well as any other type of processing device, combinations, or variations thereof.

Switching circuitry 114 is representative of various mechanical, electrical, and/or electromechanical elements capable of interfacing with power supply 105 to receive power from power supply 105, with processing circuitry 112 to receive the signals from processing circuitry 112, and with load 120 to provide power to load 120 at various times. In various AC applications, switching circuitry 114 includes three phase circuits, each corresponding to a phase of the three-phase AC power provided by power supply 105, and each including current clamping circuits. Each phase circuit is coupled to a terminal of power supply 105 and to a corresponding terminal of load 120.

Referring to a single phase circuit in an AC application for the sake of simplicity and brevity, the phase circuit includes a two solid-state switches and two current clamping circuits. In some embodiments, the phase circuit may additionally include a disconnect switch representative of a mechanical or electromechanical switch that may be mechanically turned to open (i.e., turn off) and close (i.e., turn on) circuit breaker 110.

The solid-state switches may include one or more types of transistors, such as a metal-oxide semiconductor field-effect transistor (MOSFET), a bipolar junction transistor (BJT), a junction field-effect transistor (JFET), an insulated-gate bipolar transistor (IGBT), or the like, as well as combinations and variations thereof. For example, when solid-state switches include transistors, the transistors may each include a first current path terminal (e.g., a drain), a second current path terminal (e.g., a source), and a control terminal (e.g., a gate). In some embodiments, the transistors may additionally include a body terminal.

The current clamping circuits may be representative of circuits capable of providing an alternative path for current flow other than through one or more of the solid-state switches. For example, the current clamping circuits may each include a capacitor and a thyristor (e.g., a silicon-controlled rectifier (SCR)). In some embodiments, the current clamping circuits may additionally, or alternatively, include solid-state switches, diodes, and other discrete components, as well as combinations and variations thereof.

In various embodiments, the solid-state switches and the current clamping circuits are controlled by processing circuitry 112 to control current flow through circuit breaker 110. More specifically, processing circuitry 112 provides signals to control terminals of the solid-state switches and the thyristors of the current clamping circuits to control the operational states of the components (e.g., open state (i.e., off), closed state (i.e., on)).

Processing circuitry 112 may be configured to provide the signals based on an amount of current detected at load 120. Under normal operating conditions, such as when the current at load 120 is below a threshold current, processing circuitry 112 provides signals to the solid-state switches and to the thyristors to turn the solid-state switches on and the thyristors off, thus allowing current flow from power supply 105 to load 120 via the solid-state switches. Upon detection of a fault condition (e.g., a short circuit), such as when processing circuitry 112 detects that the amount of current at load 120 exceeds the threshold current, processing circuitry 112 provides signals to one of the solid-state switches and one of the thyristors to turn the switch off and the corresponding clamping circuit on, thus allowing current flow to bypass the solid-state switch turned off and instead travel through the clamping circuit and the other solid-state switch still on. Processing circuitry 112 may determine the combination of the solid-state switch and current clamping circuit to be turned off and on, respectively, based on the polarity of the current detected at load 120.

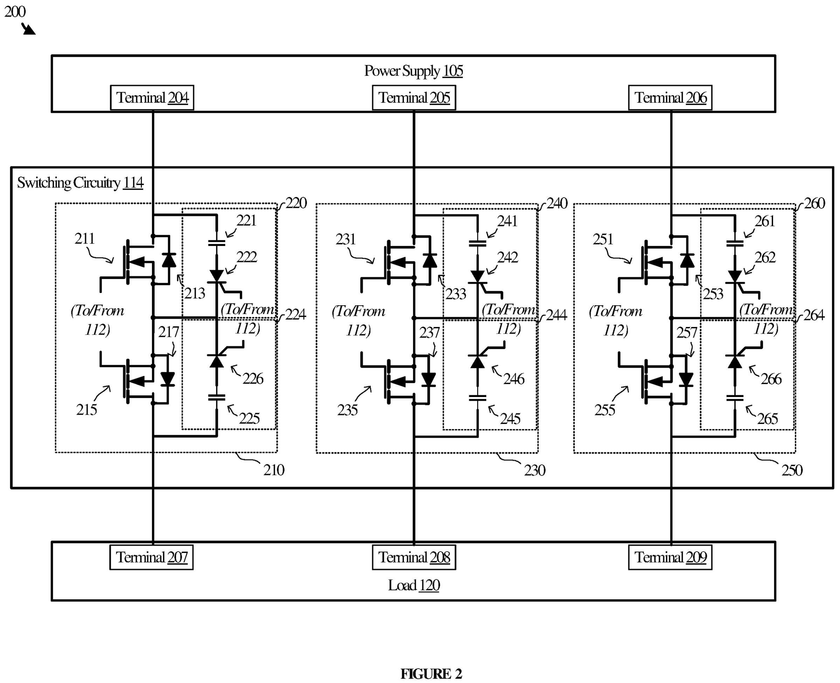

When at least one of the solid-state switches is turned off under such conditions, load 120 may be disconnected, and a voltage spike may occur in circuit breaker 110. As a result of the switching control by processing circuitry 112, current flow resulting from the voltage spike can be dissipated through one of the current clamping circuits and one of the solid-state switches, advantageously preventing damage to the solid-state switch turned off after processing circuitry 112 detects the fault condition. Figures 2 and 3 that follow show additional details of the components of switching circuitry 114 and an example series of steps for operating switching circuitry 114 like in the above example, respectively.

**Figure** 2 illustrates an example operating environment in accordance with some embodiments of the present technology. Figure 2 includes operating environment 200, which is representative of an environment in which industrial and commercial processes may be performed, and in which current flow through circuit breaker 110 can be clamped during an overload event. Operating environment 200 includes elements of operating environment 100, such as power supply 105, circuit breaker 110, and load 120, and in particular, shows example components of switching circuitry 114 of circuit breaker 110.

In operating environment 200, power supply 105 represents an AC voltage supply, and as such, includes terminals 204, 205, and 206, each representative of a phase of three-phase AC power. Switching circuitry 114 includes phase circuit 210, phase circuit 230, and phase circuit 250, each corresponding to a phase of the three-phase AC power. Load 120 includes terminals 207, 208, and 209, also each corresponding to a phase of the three-phase AC power.

More particularly, terminals 204, 205, and 206 are phase terminals of power supply 105 each corresponding to one phase of three-phase AC power produced by power supply 105. Particularly, terminal 204 corresponds to a first phase of the three-phase AC power, terminal 205 corresponds to a second phase of the three-phase AC power 120-degrees out-of-phase relative to the first phase, and terminal 206 corresponds to a third phase of the three-phase AC power 120-degrees out-of-phase relative to the first and second phases. Similarly, terminals 207, 208, and 209 are phase terminals of load 120 each corresponding to a respective one of the three-phases of AC power produced by power supply 105.

The AC power is provided from the phase terminals of power supply 105 to corresponding phase terminals of load 120 via respective phase circuits of switching circuitry 114. More specifically, terminals 204 and 207 are coupled to a first phase circuit 210, and as such, power is provided from terminal 204 to terminal 207 via phase circuit 210. Terminals 205 and 208 are coupled to a second phase circuit 230, and as such, power is provided from terminal 205 to terminal 208 via phase circuit 230. Terminals 206 and 209 are coupled to a third phase circuit 250, and as such, power is provided from terminal 206 to terminal 209 via phase circuit 250.

Phase circuits 210, 230, and 250 each include multiple switches and current clamping circuits. More specifically, phase circuit 210 includes switch 211, switch 215, current clamping circuit 220, and current clamping circuit 224, phase circuit 230 includes switch 231, switch 235, current clamping circuit 240, and current clamping circuit 244, and phase circuit 250 includes switch 251, switch 255, current clamping circuit 260, and current clamping circuit 264.

In various embodiments, switches 211, 215, 231, 235, 251, and 255 are representative of solid-state switches that may be controlled by processing circuitry 112 to turn off and on, or in other words, transition between open and closed states, respectively. For example, switches 211, 215, 231, 235, 251, and 255 are transistors controllable by signals provided by processing circuitry 112. Examples of the transistors include metal-oxide semiconductor field-effect transistors (MOSFETs), bipolar junction transistors (BJTs), junction field-effect transistors (JFETs), insulated-gate bipolar transistors (IGBTs), or the like, as well as combinations and variations thereof. In such embodiments, the transistors may each include a first current path terminal (e.g., a drain), a second current path terminal (e.g., a source), and a control terminal (e.g., a gate). In some embodiments, the transistors may additionally include a body terminal.

In various embodiments, current clamping circuits 220, 224, 240, 244, 260, and 264 are representative of circuits that include various components capable of providing a path for current flow for dissipation thereof in the event of an overload condition (e.g., a short circuit). More specifically, current clamping circuit 220 can provide a path for current flow in the direction from power supply 105 to load 120 to bypass switch 211, current clamping circuit 224 can provide a path for current flow in the direction from load 120 to power supply 105 to bypass switch 215, current clamping circuit 240 can provide a path for current flow in the direction from power supply 105 to load 120 to bypass switch 231, current clamping circuit 244 can provide a path for current flow in the direction from load 120 to power supply 105 to bypass switch 235, current clamping circuit 260 can provide a path for current flow in the direction from power supply 105 to load 120 to bypass switch 251, and current clamping circuit 264 can provide a path for current flow in the direction from load 120 to power supply 105 to bypass switch 255. Due to the configuration of the components of the current clamping circuits, current flow is prevented from flowing the direction opposite the direction described above through the current clamping circuits.

Referring more specifically to the topology of phase circuit 210, switch 211 includes a first terminal coupled to terminal 204 of power supply 105, a second terminal coupled to a first terminal of switch 215, and a third terminal coupled to processing circuitry 112. Switch 211 also includes a body diode 213 including an anode terminal coupled to the second terminal of switch 211 and a cathode terminal coupled to the first terminal of switch 211. Switch 215 includes the first terminal coupled to switch 211, a second terminal coupled to terminal 207 of load 120, and a third terminal coupled to processing circuitry 112. Switch 215 also includes a body diode 217 including an anode terminal coupled to the first terminal of switch 215 and a cathode terminal coupled to the second terminal of switch 215. Current clamping circuit 220 includes an input terminal coupled to terminal 204 and to the first terminal of switch 211, and an output terminal coupled to the second terminal of switch 211 and the first terminal of switch 215. Current clamping circuit 224 includes an input terminal coupled to terminal 207 of load 120 and to the second terminal of switch 215, and an output terminal coupled to the second terminal of switch 211 and the first terminal of switch 215.

Current clamping circuit 220 includes capacitor 221 and thyristor 222. Capacitor 221 includes a first terminal (the same as the input terminal of current clamping circuit 220) coupled to the first terminal of switch 211 and to terminal 204 of power supply 105, and a second terminal coupled to an anode terminal of thyristor 222. Thyristor 222 includes the anode terminal, a cathode terminal (the same as the output terminal of current clamping circuit 220) coupled to the second terminal of switch 211 and to the first terminal of switch 215, and a third terminal coupled to processing circuitry 112.

Current clamping circuit 224 includes capacitor 225 and thyristor 226. Capacitor 225 includes a first terminal (the same as the input terminal of current clamping circuit 220) coupled to the first terminal of switch 215 and to terminal 207 of load 120, and a second terminal coupled to an anode terminal of thyristor 226. Thyristor 226 includes the anode terminal, a cathode terminal (the same as the output terminal of current clamping circuit 224) coupled to the second terminal of switch 211 and to the first terminal of switch 215, and a third terminal coupled to processing circuitry 112.

Referring next to the topology of phase circuit 230, switch 231 includes a first terminal coupled to terminal 205 of power supply 105, a second terminal coupled to a first terminal of switch 235, and a third terminal coupled to processing circuitry 112. Switch 231 also includes a body diode 233 including an anode terminal coupled to the second terminal of switch 231 and a cathode terminal coupled to the first terminal of switch 231. Switch 235 includes the first terminal coupled to switch 231, a second terminal coupled to terminal 208 of load 120, and a third terminal coupled to processing circuitry 112. Switch 235 also includes a body diode 237 including an anode terminal coupled to the first terminal of switch 235 and a cathode terminal coupled to the second terminal of switch 235. Current clamping circuit 240 includes an input terminal coupled to terminal 205 and to the first terminal of switch 231, and an output terminal coupled to the second terminal of switch 231 and the first terminal of switch 235. Current clamping circuit 244 includes an input terminal coupled to terminal 208 of load 120 and to the second terminal of switch 235, and an output terminal coupled to the second terminal of switch 231 and the first terminal of switch 235.

Current clamping circuit 240 includes capacitor 241 and thyristor 242. Capacitor 241 includes a first terminal (the same as the input terminal of current clamping circuit 240) coupled to the first terminal of switch 231 and to terminal 205 of power supply 105, and a second terminal coupled to an anode terminal of thyristor 242. Thyristor 242 includes the anode terminal, a cathode terminal (the same as the output terminal of current clamping circuit 240) coupled to the second terminal of switch 231 and to the first terminal of switch 235, and a third terminal coupled to processing circuitry 112.

Current clamping circuit 244 includes capacitor 245 and thyristor 246. Capacitor 245 includes a first terminal (the same as the input terminal of current clamping circuit 240) coupled to the first terminal of switch 235 and to terminal 208 of load 120, and a second terminal coupled to an anode terminal of thyristor 246. Thyristor 246 includes the anode terminal, a cathode terminal (the same as the output terminal of current clamping circuit 244) coupled to the second terminal of switch 231 and to the first terminal of switch 235, and a third terminal coupled to processing circuitry 112.

Referring next to the topology of phase circuit 250, switch 251 includes a first terminal coupled to terminal 206 of power supply 105, a second terminal coupled to a first terminal of switch 255, and a third terminal coupled to processing circuitry 112. Switch 251 also includes a body diode 253 including an anode terminal coupled to the second terminal of switch 251 and a cathode terminal coupled to the first terminal of switch 251. Switch 255 includes the first terminal coupled to switch 251, a second terminal coupled to terminal 209 of load 120, and a third terminal coupled to processing circuitry 112. Switch 255 also includes a body diode 257 including an anode terminal coupled to the first terminal of switch 255 and a cathode terminal coupled to the second terminal of switch 255. Current clamping circuit 260 includes an input terminal coupled to terminal 206 and to the first terminal of switch 251, and an output terminal coupled to the second terminal of switch 251 and the first terminal of switch 255. Current clamping circuit 264 includes an input terminal coupled to terminal 209 of load 120 and to the second terminal of switch 255, and an output terminal coupled to the second terminal of switch 251 and the first terminal of switch 255.

Current clamping circuit 260 includes capacitor 261 and thyristor 262. Capacitor 261 includes a first terminal (the same as the input terminal of current clamping circuit 260) coupled to the first terminal of switch 261 and to terminal 206 of power supply 105, and a second terminal coupled to an anode terminal of thyristor 262. Thyristor 262 includes the anode terminal, a cathode terminal (the same as the output terminal of current clamping circuit 260) coupled to the second terminal of switch 251 and to the first terminal of switch 255, and a third terminal coupled to processing circuitry 112.

Current clamping circuit 264 includes capacitor 265 and thyristor 266. Capacitor 265 includes a first terminal (the same as the input terminal of current clamping circuit 260) coupled to the first terminal of switch 255 and to terminal 209 of load 120, and a second terminal coupled to an anode terminal of thyristor 266. Thyristor 266 includes the anode terminal, a cathode terminal (the same as the output terminal of current clamping circuit 264) coupled to the second terminal of switch 251 and to the first terminal of switch 255, and a third terminal coupled to processing circuitry 112.

In operation, in an on mode of circuit breaker 110, processing circuitry 112 provides signals to switches 211, 215, 231, 235, 251, and 255 to turn the switches on allowing current flow from respective terminals of power supply 105 to corresponding respective terminals of load 120. Processing circuitry 112 may also provide signals to thyristors 222, 226, 242, 246, 262, and 266 to gate the thyristors, preventing current through current clamping circuits 220, 224, 240, 244, 260, and 264, respectively.

While current flows through phase circuits 210, 230, and 250 from power supply 105 to load 120 based on the signals provided to the elements of phase circuits 210, 230, and 250, processing circuitry 112 monitors the current at terminals 207, 208, and 209 of load 120. To do so, circuit breaker 110 includes one or more current sensors, among other types of sensors, coupled to outputs of switching circuitry 114.

If processing circuitry 112 determines the amount of current (e.g., magnitude, amplitude) is below a threshold current indicative of an overload or fault condition, processing circuitry 112 provides the same signals to the switches and thyristors of switching circuitry 114 to continue allowing current flow from power supply 105 to load 120. If processing circuitry 112 determines the amount of current exceeds the threshold current, processing circuitry 112 identifies the polarity of the current and provides signals to the switches and thyristors to control paths for the current flow based on the polarity.

The following discussion applies to current having a polarity indicative of current flow from power supply 105 to load 120. With respect to phase circuit 210, processing circuitry 112 provides signals to switch 211 and thyristor 222 of phase circuit 210 to turn switch 211 off and turn thyristor 222 on, allowing current flow from terminal 204 of power supply 105 to terminal 207 of load 120 through current clamping circuit 220 and switch 215, bypassing switch 211. With respect to phase circuit 230, processing circuitry 112 provides signals to switch 231 and thyristor 242 of phase circuit 230 to turn switch 231 off and turn thyristor 242 on, allowing current flow from terminal 205 of power supply 105 to terminal 208 of load 120 through current clamping circuit 240 and switch 235, bypassing switch 231. With respect to phase circuit 250, processing circuitry 112 provides signals to switch 251 and thyristor 262 of phase circuit 250 to turn switch 251 off and turn thyristor 262 on, allowing current flow from terminal 206 of power supply 105 to terminal 209 of load 120 through current clamping circuit 260 and switch 255, bypassing switch 251. Additionally, processing circuitry 112 may provide signals to switch 215 and to thyristor 226 to keep switch 215 on and current clamping circuit 224 off, to switch 235 and to thyristor 246 to keep switch 235 on and current clamping circuit 244 off, and to switch 255 and to thyristor 266 to keep switch 255 on and current clamping circuit 264 off. Based on the polarity of the current and the configurations of current clamping circuit 220 and switch 215, current clamping circuit 240 and switch 235, and current clamping circuit 260 and switch 255, the current within switching circuitry 114 dissipates and eventually falls below the threshold current for safe shut-down of circuit breaker 110. Once processing circuitry 112 determines that the current within each phase circuit falls to zero Amps, processing circuitry can provide signals to thyristors 222, 242, and 262 to turn the thyristors off and gate current clamping circuits 220, 240, and 260, respectively. Upon resolution of the fault condition, processing circuitry 112 can provide signals to switching circuitry 114 to turn circuit breaker 110 back on under normal operating conditions.

The following discussion applies to current having a polarity indicative of current flow from load 120 to power supply 105. With respect to phase circuit 210, processing circuitry 112 provides signals to switch 215 and thyristor 226 of phase circuit 210 to turn switch 215 off and turn thyristor 226 on, allowing current flow from terminal 207 of load to terminal 204 of power supply 105 through current clamping circuit 224 and switch 211, bypassing switch 215. With respect to phase circuit 230, processing circuitry 112 provides signals to switch 235 and thyristor 246 of phase circuit 230 to turn switch 235 off and turn thyristor 246 on, allowing current flow from terminal 208 of load 120 to terminal 205 of power supply 105 through current clamping circuit 244 and switch 231, bypassing switch 235. With respect to phase circuit 250, processing circuitry 112 provides signals to switch 255 and thyristor 266 of phase circuit 250 to turn switch 255 off and turn thyristor 266 on, allowing current flow from terminal 209 of load 120 to terminal 206 of power supply 105 through current clamping circuit 264 and switch 251, bypassing switch 255. Additionally, processing circuitry 112 may provide signals to switch 211 and to thyristor 222 to keep switch 211 on and current clamping circuit 220 off, to switch 231 and to thyristor 242 to keep switch 231 on and current clamping circuit 240 off, and to switch 251 and to thyristor 262 to keep switch 251 on and current clamping circuit 262 off. Based on the polarity of the current and the configurations of current clamping circuit 240 and switch 211, current clamping circuit 244 and switch 231, and current clamping circuit 264 and switch 251, the current within switching circuitry 114 dissipates and eventually falls below the threshold current for safe shut-down of circuit breaker 110. Once processing circuitry 112 determines that the current within each phase circuit falls to zero Amps, processing circuitry 112 can provide signals to thyristors 226, 246, and 266 to turn the thyristors off and gate current clamping circuits 224, 244, and 264, respectively. Upon resolution of the fault condition, processing circuitry 112 can provide signals to switching circuitry 114 to turn circuit breaker 110 back on under normal operating conditions.

In various embodiments, with current flowing in either direction, processing circuitry 112 may turn the current clamping circuits on before turning some of the switches off. In this way, processing circuitry 112 provides an alternative current path for the current to and from power supply 105 and load 120 to help minimize the risk to the switches upon breaking the current flow resulting in a voltage transient.

In some embodiments, other sequences of voltages and leakage current flow may be contemplated. In some embodiments, additional, fewer, or different components may be included in switching circuitry 114, and in particular, in the current clamping circuits thereof. For example, instead of a capacitor-thyristor combination, the current clamping circuits may include a solid-state switch, a capacitor and diode coupled in series, or other current source components. Other types of diodes, thyristors, resistors, or other current sourcing or impeding devices, as well as combinations and variations thereof, may be contemplated.

**Figure 3** includes method 300, which references elements of operating environment 100 of Figure 1 and operating environment 200 of Figure 2. In various embodiments, method 300 may be implemented in hardware, software, firmware, or any combination or variation. For example, method 300 may be implemented by processing circuitry 112 of circuit breaker 110 of operating environment 100.

In operation 310, processing circuitry 112 monitors current at load 120. In various embodiments, circuit breaker 110 includes one or more current and/or voltage sensors coupled to terminals of components of circuit breaker 110, power supply 105, and load 120. Accordingly, processing circuitry 112 can detect values associated with the current at load 120, among other locations within operating environment 100, such as the amplitude, magnitude, and polarity of the current.

In operation 311, processing circuitry 112 determines whether there is a fault condition at circuit breaker 110 based on the current measured at load 120. By way of example, processing circuitry 112 determines an amount (e.g., magnitude) of current at load 120, performs a comparison between the amount of current at load 120 and a threshold current, and determines whether there is a fault condition based on the results of the comparison. In at least this example, the threshold current corresponds to an amount of current indicative of a fault condition, such as an overcurrent condition or a short-circuit.

If processing circuitry 112 does not detect a fault condition in operation 311, in operation 312, processing circuitry 112 provides signals to the solid-state switches of switching circuitry 114 to allow current flow from power supply 105 to load 120 via switching circuitry 114. In particular, processing circuitry 112 provides the signals to control terminals of the solid-state switches (e.g., switches 211, 215, 231, 235, 251, and 255) to turn the solid-state switches on, and thus, the solid-state switches operate like closed switches. Processing circuitry 112 can then continue to monitor the current at load 120 as in operations 210 and 211.

If processing circuitry 112 detects a fault condition in operation 311, in operation 313, processing circuitry 112 identifies the polarity of the current, and consequently the direction that the breaking current will flow through switching circuitry 114 upon turning one or more of the solid-state switches off to prevent damage to circuit breaker 110.

For a polarity corresponding to a line-to-load current flow (i.e., current flowing from power supply 105 to load 120), in operation 314, processing circuitry 112 provides signals to various switches and current clamping circuits of phase circuits 210, 230, and 250 to control paths for the current flow. With respect to phase circuit 210, processing circuitry 112 provides signals to switch 211 and thyristor 222 of phase circuit 210 to turn switch 211 off and turn thyristor 222 on, allowing current flow from terminal 204 of power supply 105 to terminal 207 of load 120 through current clamping circuit 220 and switch 215, bypassing switch 211. With respect to phase circuit 230, processing circuitry 112 provides signals to switch 231 and thyristor 242 of phase circuit 230 to turn switch 231 off and turn thyristor 242 on, allowing current flow from terminal 205 of power supply 105 to terminal 208 of load 120 through current clamping circuit 240 and switch 235, bypassing switch 231. With respect to phase circuit 250, processing circuitry 112 provides signals to switch 251 and thyristor 262 of phase circuit 250 to turn switch 251 off and turn thyristor 262 on, allowing current flow from terminal 206 of power supply 105 to terminal 209 of load 120 through current clamping circuit 260 and switch 255, bypassing switch 251. Additionally, processing circuitry 112 may provide signals to switch 215 and to thyristor 226 to keep switch 215 on and current clamping circuit 224 off, to switch 235 and to thyristor 246 to keep switch 235 on and current clamping circuit 244 off, and to switch 255 and to thyristor 266 to keep switch 255 on and current clamping circuit 264 off. Based on the polarity of the current and the configurations of current clamping circuit 220 and switch 215, current clamping circuit 240 and switch 235, and current clamping circuit 260 and switch 255, the current within switching circuitry 114 dissipates and eventually falls below the threshold current for safe shut-down of circuit breaker 110.

In operation 315, once processing circuitry 112 determines that the current within each phase circuit falls to zero Amps, in operation 316, processing circuitry can provide signals to thyristors 222, 242, and 262 to turn the thyristors off and gate current clamping circuits 220, 240, and 260, respectively. Upon resolution of the fault condition, processing circuitry 112 can provide signals to switching circuitry 114 to turn circuit breaker 110 back on under normal operating conditions.

For a polarity corresponding to a line-to-load current flow (i.e., current flowing from power supply 105 to load 120), in operation 317, processing circuitry 112 provides signals to various switches and current clamping circuits of phase circuits 210, 230, and 250 to control paths for the current flow. With respect to phase circuit 210, processing circuitry 112 provides signals to switch 215 and thyristor 226 of phase circuit 210 to turn switch 215 off and turn thyristor 226 on, allowing current flow from terminal 207 of load to terminal 204 of power supply 105 through current clamping circuit 224 and switch 211, bypassing switch 215. With respect to phase circuit 230, processing circuitry 112 provides signals to switch 235 and thyristor 246 of phase circuit 230 to turn switch 235 off and turn thyristor 246 on, allowing current flow from terminal 208 of load 120 to terminal 205 of power supply 105 through current clamping circuit 244 and switch 231, bypassing switch 235. With respect to phase circuit 250, processing circuitry 112 provides signals to switch 255 and thyristor 266 of phase circuit 250 to turn switch 255 off and turn thyristor 266 on, allowing current flow from terminal 209 of load 120 to terminal 206 of power supply 105 through current clamping circuit 264 and switch 251, bypassing switch 255. Additionally, processing circuitry 112 may provide signals to switch 211 and to thyristor 222 to keep switch 211 on and current clamping circuit 220 off, to switch 231 and to thyristor 242 to keep switch 231 on and current clamping circuit 240 off, and to switch 251 and to thyristor 262 to keep switch 251 on and current clamping circuit 262 off. Based on the polarity of the current and the configurations of current clamping circuit 240 and switch 211, current clamping circuit 244 and switch 231, and current clamping circuit 264 and switch 251, the current within switching circuitry 114 dissipates and eventually falls below the threshold current for safe shut-down of circuit breaker 110.

In operation 318, once processing circuitry 112 determines that the current within each phase circuit falls to zero Amps, in operation 319, processing circuitry 112 can provide signals to thyristors 226, 246, and 266 to turn the thyristors off and gate current clamping circuits 224, 244, and 264, respectively. Upon resolution of the fault condition, processing circuitry 112 can provide signals to switching circuitry 114 to turn circuit breaker 110 back on under normal operating conditions.

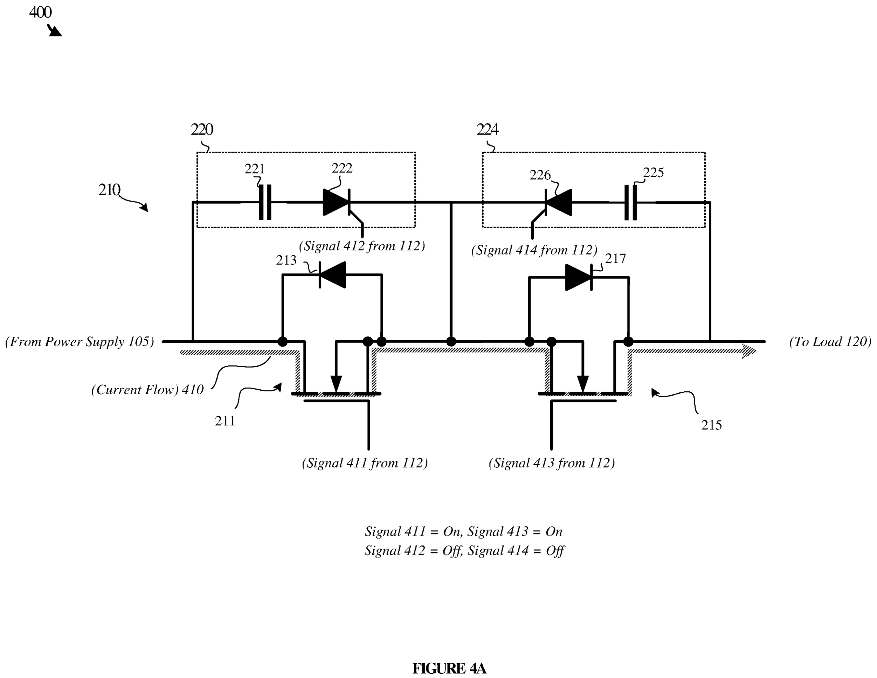

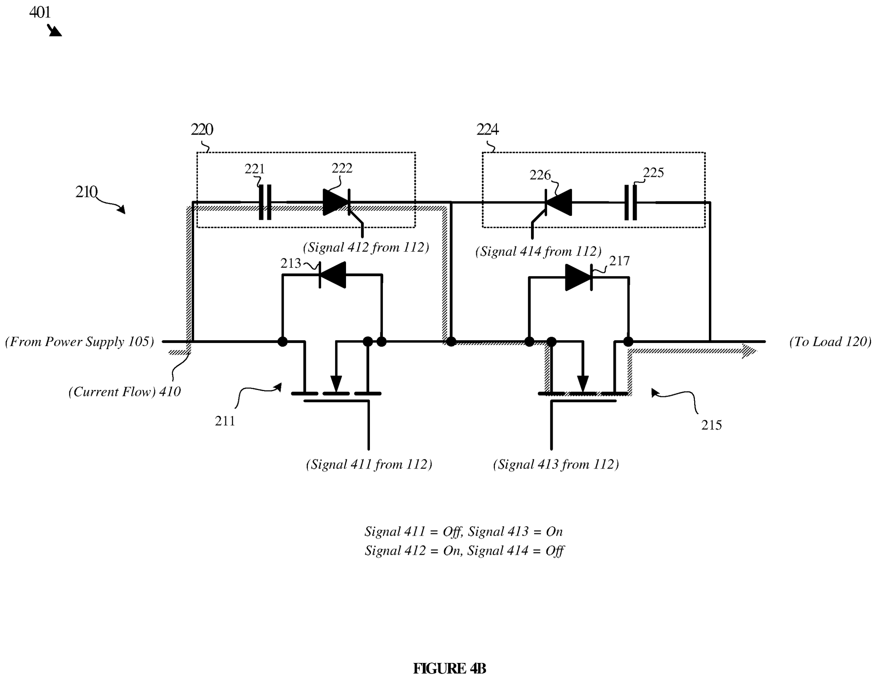

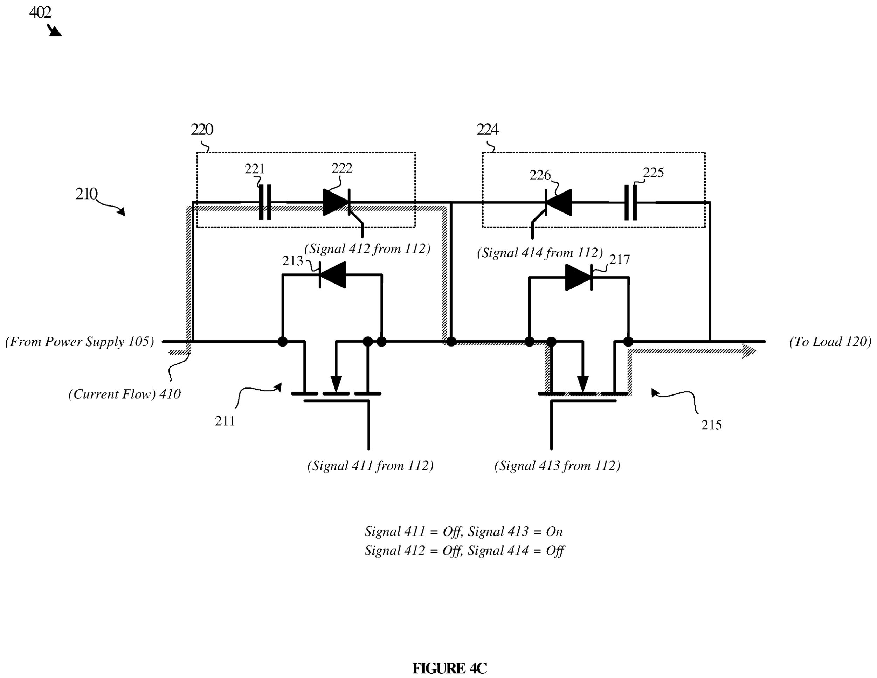

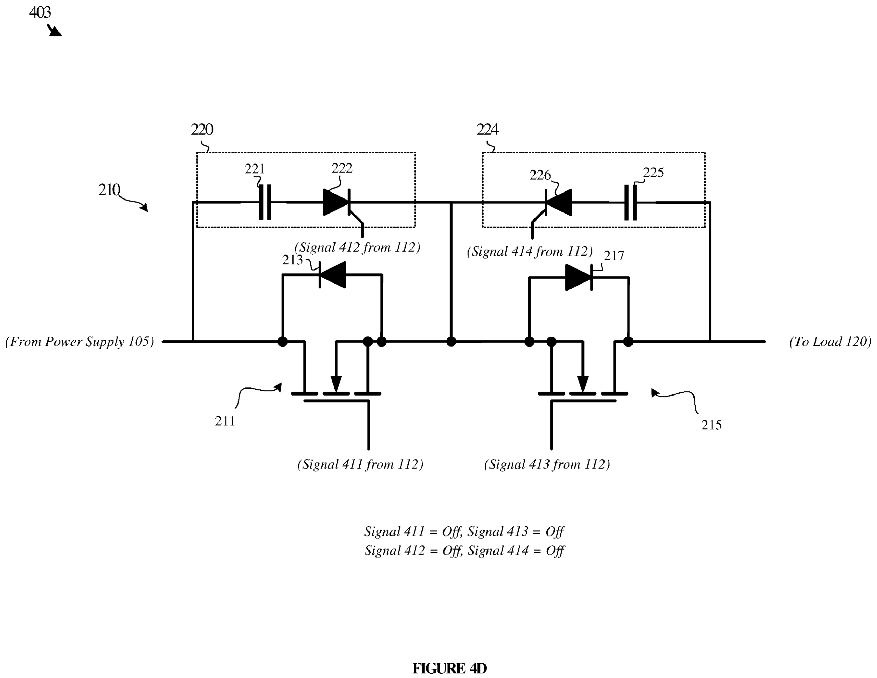

**Figures 4A****,** **4B****,** **4C****, and** **4D** illustrate example aspects of switching circuitry of a circuit breaker and resulting current flow through the elements of the switching circuitry during operation in accordance with some embodiments of the present technology. Figure 4A includes aspect 400, Figure 4B includes aspect 401, Figure 4C includes aspect 402, and Figure 4D includes 403, which all include phase circuit 210 of switching circuitry 114 of operating environment 200.

Referring generally to phase circuit 210 shown in each of Figures 4A-4D, phase circuit 210 is representative of circuitry capable of operating in various modes to allow or restrict current flow from power supply 105 to load 120. In various embodiments where power supply 105 includes an AC power source, phase circuit 210 is one of three sub-circuits of switching circuitry 114 that can provide power of a single phase of three-phase AC power generated by power supply 105. Phase circuit 210 includes switch 211, diode 213, current clamping circuit 220, switch 215, diode 217, and current clamping circuit 224. Current clamping circuit 220 includes capacitor 221 and thyristor 222, and current clamping circuit 224 includes capacitor 225 and thyristor 226. Other sub-circuits of switching circuitry 114 as shown in operating environment 200, phase circuits 230 and 250, are not shown in Figures 4A-4D for the sake of simplicity.

Referring first to aspect 400 of Figure 4A, aspect 400 shows a first mode of operation of circuit breaker 110 corresponding to an on mode in which current flow 410 travels from power supply 105 to load 120 via phase circuit 210. In the on mode, processing circuitry 112 provides signals 411, 412, 413, and 414 to control terminals of switch 211, thyristor 222, switch 215, and thyristor 225 of phase circuit 210, respectively. Signal 411 includes an indication to turn on, signal 412 includes an indication to turn off, signal 413 includes an indication to turn on, and signal 414 includes an indication to turn off. Accordingly, switches 211 and 215 turn on, while current clamping circuits 220 and 224 are gated, and thus, current flow 410 travels from power supply 105 to load 120 via a path through current path terminals of switches 211 and 215.

Referring next to aspect 401 of Figure 4B, aspect 401 shows a second mode of operation of circuit breaker 110 corresponding to a tripped mode in which current produced by a voltage transient in response to a fault condition is broken within phase circuit 210. In this mode, and based on the direction of current flow 410 from power supply 105 to load 120, processing circuitry 112 provides signals 411, 412, 413, and 414 to control terminals of switch 211, thyristor 222, switch 215, and thyristor 225 of phase circuit 210, respectively, in which signal 411 includes an indication to turn off, signal 412 includes an indication to turn on, signal 413 includes an indication to turn on, and signal 414 includes an indication to turn off. Accordingly, switch 211 turns off, current clamping circuit 220 turns on, switch 215 turns (or remains) on, and current clamping circuit 224 turns (or remains) off. Based on the signals, current flow 410 travels in the direction from power supply 105 to load 120 via a path through current clamping circuit 220 and switch 215 bypassing switch 211.

Referring next to aspect 402 of Figure 4C, aspect 403 shows a third mode of operation of circuit breaker 110 corresponding to the tripped mode in which current produced by a voltage transient in response to a fault condition is broken within phase circuit 210 but has fallen below a threshold current. At this time, and based on the direction of current flow 410 from power supply 105 to load 120, processing circuitry 112 provides signals 411, 412, 413, and 414 to control terminals of switch 211, thyristor 222, switch 215, and thyristor 225 of phase circuit 210, respectively, in which signal 411 includes an indication to turn off, signal 412 includes an indication to turn off, signal 413 includes an indication to turn on, and signal 414 includes an indication to turn off. Accordingly, switch 211 turns off, current clamping circuit 220 turns off, switch 215 turns (or remains) on, and current clamping circuit 224 turns (or remains) off. Based on the signals, current flow 410 travels in the direction from power supply 105 to load 120 via a path through current clamping circuit 220 and switch 215 bypassing switch 211. However, based on signal 412 gating current clamping circuit 220, current flow 410 eventually stops as the amount of current falls to zero amps.

Referring lastly to aspect 403 of Figure 4D, aspect 403 shows a fourth mode of operation of circuit breaker 110 corresponding to the off mode in which current flow through phase circuit 210 is prevented. At this time, processing circuitry 112 provides signals 411, 412, 413, and 414 to control terminals of switch 211, thyristor 222, switch 215, and thyristor 225 of phase circuit 210, respectively, where each signal includes an indication to turn off. Accordingly, each element of phase circuit 210 turns off and prevents current flow between power supply 105 and load 120.

Additionally, processing circuitry 112 can perform switching operations with each of the phase circuits to dissipate current flow in the direction from load 120 to power supply 105. For example, processing circuitry 112 provides signals 411, 412, 413, and 414 having values such that current flow in the direction from load 120 to power supply 105 travels through current clamping circuit 224 and switch 211, bypassing switch 215.

While other phase circuits are not shown in Figures 4A-4D, processing circuitry 112 can control current flow through the other phase circuits in a similar manner, which may help dissipate current generated from a transient voltage and break such current through the use of one or more of the current clamping circuits of switching circuitry 114.

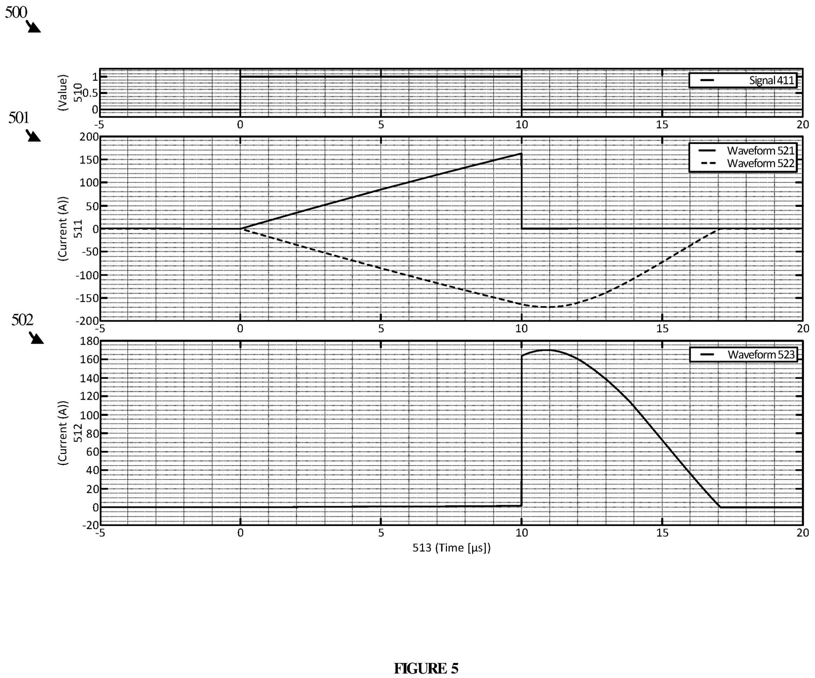

**Figure 5** illustrates example graphical representations related to switching operations of a circuit breaker in accordance with some embodiments of the present technology. Figure 5 shows graphical representation 500, 501, and 502, which reference elements of Figures 1, 2, and 4A-4D, such as switch 211, switch 215, and thyristor 222 of phase circuit 210, and signal 411 provided to switch 211 by processing circuitry 112.

Graphical representation 500 includes a waveform representative of signal 411 and a corresponding value 510. Value 510 includes logical state values indicative of an off mode (0, e.g., a logical low state) and an on mode (1, e.g., a logical high state). Processing circuitry 112 generates signal 411 having value 510 and provides signal 411 to the control terminal of switch 211 to control a mode (e.g., on, off) of switch 211.

Graphical representation 501 includes waveforms 521 and 522 with respect to current 511 and time 513. Waveform 521 corresponds to a current flowing through current path terminals (e.g., drain-to-source) of switch 211, and waveform 522 corresponds to a current flowing through current path terminals of switch 215.

Graphical representation 502 includes waveform 523 with respect to current 512 and time 513. Waveform 523 corresponds to a current flowing through thyristor 522 in operation of phase circuit 210.

The following discussion refers to the waveforms of graphical representations 501, 502, and 503 interchangeably as they relate to operations of phase circuit 210 with respect to time 513. At a first time, such as 0 seconds with respect to time 513, processing circuitry 112 provides signal 411 having a value indicative of the on mode, or "1" with respect to value 510, to the control terminal of switch 211. Switch 211 turns on based on signal 411. Additionally at this time, processing circuitry 112 may provide a signal (e.g., signal 413) having the same value to the control terminal of switch 215. Switch 215 also turns on based on this signal. Accordingly, current flows from power supply 105 to load 120 via switches 211 and 215 of phase circuit 210 as evidenced by waveform 521 increasing from 0 amps with respect to current 511 to a positive non-zero current and by waveform 522 increasing from 0 amps with respect to current 511 to a negative non-zero current.

At a second time, such as 10 seconds with respect to time 513, a fault condition occurs within circuit breaker 110, and processing circuitry 112 provides signal 411 having a value indicative of the off mode, or "0" with respect to value 510, to the control terminal of switch 211. Switch 211 turns off based on signal 411. Additionally at this time, processing circuitry 112 may provide a signal (e.g., signal 412) having a value indicative of the on mode, or "0" with respect to value 510, to the control terminal of thyristor 222. Thyristor 222 turns on based on this signal. As a result of switch 211 turning off and thyristor 222 turning on, the current through switch 211 falls to 0 amps as shown by waveform 521, and the current through thyristor 222 spikes to a positive non-zero current as shown by waveform 523.

From the second time (10 seconds) to a third time, such as 17 seconds with respect to time 513, the current flows in the direction from power supply 105 to load 120 through current clamping circuit 220 and switch 215, bypassing switch 211, and eventually falls to 0 amps as evidenced by waveforms 522 and 523. In this way, the spike in current created by the fault condition is broken via current clamping circuit 220 and switch 215 based on the signals provided to respective elements thereof by processing circuitry 112.

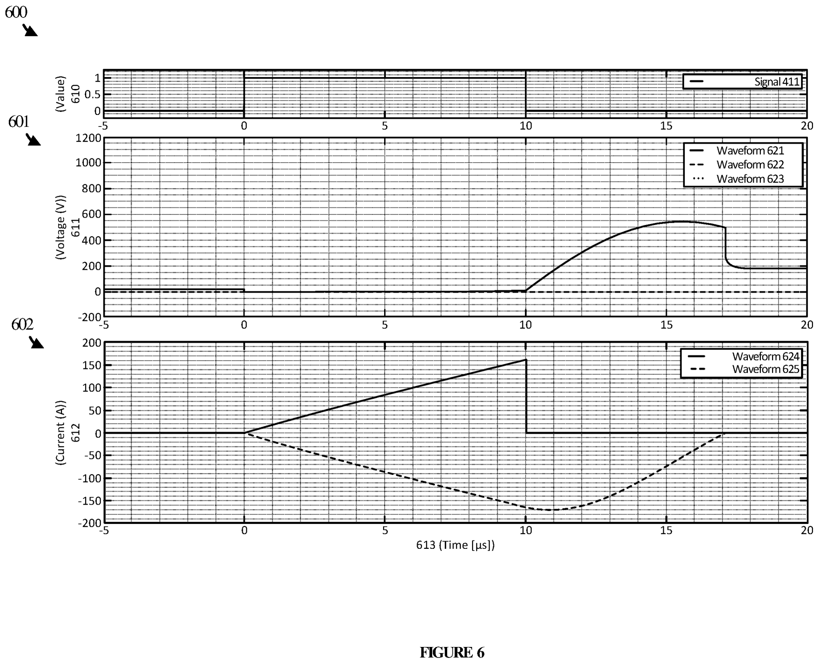

**Figure 6** illustrates example graphical representations related to switching operations of a circuit breaker in accordance with some embodiments of the present technology. Figure 6 shows graphical representation 600, 601, and 602, which reference elements of Figures 1, 2, and 4A-4D, such as switch 211, switch 215, and thyristor 222 of phase circuit 210, and signal 411 provided to switch 211 by processing circuitry 112.

Graphical representation 600 includes a waveform representative of signal 411 and a corresponding value 610. Value 610 includes logical state values indicative of an off mode (0, e.g., a logical low state) and an on mode (1, e.g., a logical high state). Processing circuitry 112 generates signal 411 having value 610 and provides signal 411 to the control terminal of switch 211 to control a mode (e.g., on, off) of switch 211.

Graphical representation 601 includes waveforms 621, 622, and 623 with respect to voltage 611 and time 613. Waveform 621 corresponds to a voltage (e.g., drain-to-source) of switch 211, waveform 622 corresponds to a voltage (e.g., drain-to-source) of switch 215, and waveform 623 corresponds to a voltage rating of switches 211 and 215.

Graphical representation 602 includes waveforms 624 and 625 with respect to current 612 and time 613. Waveform 624 corresponds to a current (e.g., drain-to-source) through current path terminals of switch 211, and waveform 625 corresponds to a current (e.g., drain-to-source) through current path terminals of switch 215.

The following discussion refers to the waveforms of graphical representations 601, 602, and 603 interchangeably as they relate to operations of phase circuit 210 with respect to time 613. At a first time, such as 0 seconds with respect to time 613, processing circuitry 112 provides signal 411 having a value indicative of the on mode, or "1" with respect to value 610, to the control terminal of switch 211. Switch 211 turns on based on signal 411. Additionally at this time, processing circuitry 112 may provide a signal (e.g., signal 413) having the same value to the control terminal of switch 215. Switch 215 also turns on based on this signal. Accordingly, current flows from power supply 105 to load 120 via switches 211 and 215 of phase circuit 210 as evidenced by waveforms 624 and 625 increasing from 0 amps with respect to current 612 to non-zero values.

At a second time, such as 10 seconds with respect to time 613, a fault condition occurs within circuit breaker 110, and processing circuitry 112 provides signal 411 having a value indicative of the off mode, or "0" with respect to value 610, to the control terminal of switch 211. Switch 211 turns off based on signal 411. Additionally at this time, processing circuitry 112 may provide a signal (e.g., signal 412) having a value indicative of the on mode, or "0" with respect to value 610, to the control terminal of thyristor 222. Thyristor 222 turns on based on this signal. As a result of switch 211 turning off and thyristor 222 turning on, the current through switch 211 falls to 0 amps as shown by waveform 624, and the current through switch 215 increases slightly, then begins to falls as shown by waveform 625.

At the second time, while the current through switch 211 falls to zero amps as shown by waveform 624, the voltage at switch 211 increases as shown by waveform 621 as a result of a voltage transient occurring within phase circuit 210. Notably, the voltage at switch 211 does not increase beyond a threshold voltage rating (e.g., 1200 Volts) due to the current dissipation path provided by current clamping circuit 220 and the switching operations performed by processing circuitry 112 to control the flow of current.

From the second time (10 seconds) to a third time, such as 17 seconds with respect to time 513, the current flows in the direction from power supply 105 to load 120 through current clamping circuit 220 and switch 215, bypassing switch 211, and eventually falls to 0 amps as evidenced by waveform 625. In this way, the spike in current created by the fault condition is broken via current clamping circuit 220 and switch 215 based on the signals provided to respective elements thereof by processing circuitry 112.

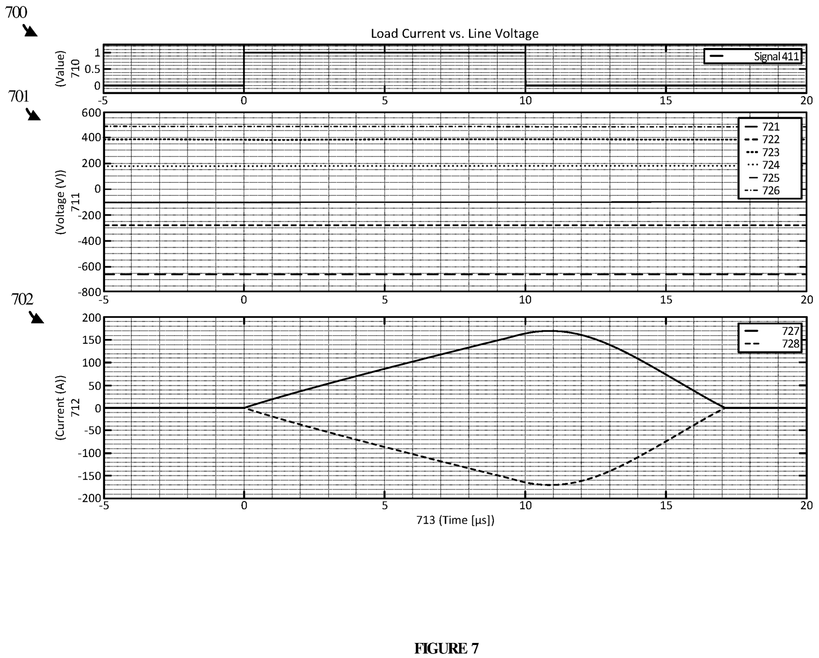

**Figure 7** illustrates example graphical representations related to switching operations of a circuit breaker in accordance with some embodiments of the present technology. Figure 7 shows graphical representation 700, 701, and 702, which reference elements of Figures 1, 2, and 4A-4D, such as power supply 105, load 120, switch 211, switch 215, and thyristor 222 of phase circuit 210, and signal 411 provided to switch 211 by processing circuitry 112.

Graphical representation 700 includes a waveform representative of signal 411 and a corresponding value 710. Value 710 includes logical state values indicative of an off mode (0, e.g., a logical low state) and an on mode (1, e.g., a logical high state). Processing circuitry 112 generates signal 411 having value 710 and provides signal 411 to the control terminal of switch 211 to control a mode (e.g., on, off) of switch 211.

Graphical representation 701 includes waveforms 721, 722, 723, 724, 725, and 726 with respect to voltage 711 and time 713. Each of these waveforms corresponds to a voltage measured at a terminal of power supply 105 or load 120, such as terminals 204, 205, 206, 207, 208, and 209, respectively.

Graphical representation 702 includes waveforms 727 and 728 with respect to current 712 and time 713. Waveforms 727 and 728 both correspond to current measured at load 120.

The following discussion refers to the waveforms of graphical representations 701, 702, and 703 interchangeably as they relate to operations of phase circuit 210 with respect to time 713. At a first time, such as 0 seconds with respect to time 713, processing circuitry 112 provides signal 411 having a value indicative of the on mode, or "1" with respect to value 710, to the control terminal of switch 211. Switch 211 turns on based on signal 411. Additionally at this time, processing circuitry 112 may provide a signal (e.g., signal 413) having the same value to the control terminal of switch 215. Switch 215 also turns on based on this signal. Accordingly, current flows from power supply 105 to load 120 via switches 211 and 215 of phase circuit 210 as evidenced by waveforms 727 and 728 increasing from 0 amps with respect to current 712 to non-zero values.

At a second time, such as 10 seconds with respect to time 713, a fault condition occurs within circuit breaker 110, and processing circuitry 112 provides signal 411 having a value indicative of the off mode, or "0" with respect to value 710, to the control terminal of switch 211. Switch 211 turns off based on signal 411. Additionally at this time, processing circuitry 112 may provide a signal (e.g., signal 412) having a value indicative of the on mode, or "0" with respect to value 710, to the control terminal of thyristor 222. Thyristor 222 turns on based on this signal. As a result of switch 211 turning off and thyristor 222 turning on, the current at load 120 increases (at least momentarily) as shown by waveforms 727 and 728.

From the second time (10 seconds) to a third time, such as 17 seconds with respect to time 513, the current flows in the direction from power supply 105 to load 120 through current clamping circuit 220 and switch 215, bypassing switch 211, and eventually falls to 0 amps as evidenced by waveforms 727 and 728. In this way, the spike in current created by the fault condition is broken via current clamping circuit 220 and switch 215 based on the signals provided to respective elements thereof by processing circuitry 112.

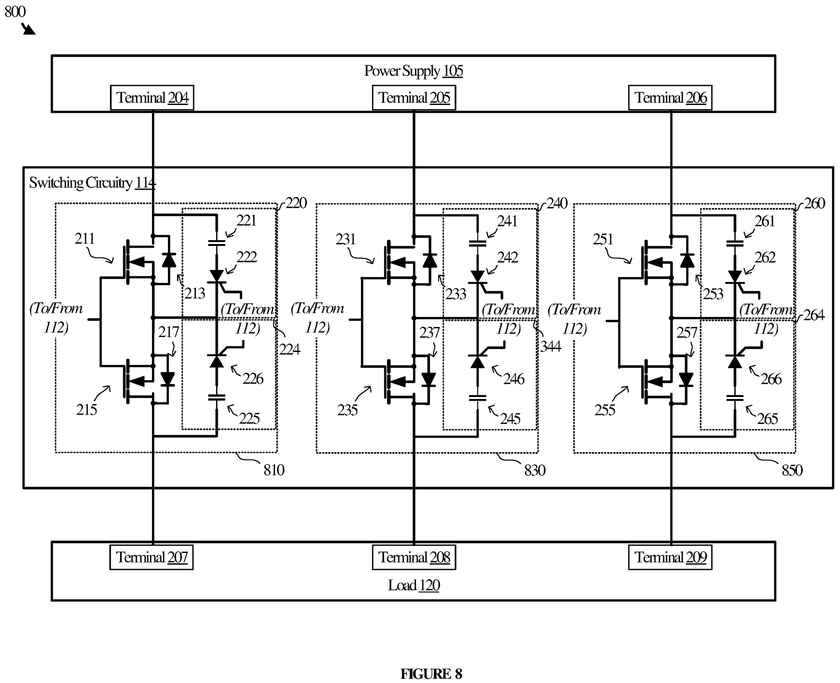

**Figure 8** illustrates an example operating environment in accordance with some embodiments of the present technology. Figure 8 includes operating environment 800, which is representative of an environment in which industrial and commercial processes may be performed, and in which current flow through circuit breaker 110 can be clamped during an overload event. Operating environment 800 includes elements of operating environment 100, such as power supply 105, circuit breaker 110, and load 120, and in particular, shows example components of switching circuitry 114 of circuit breaker 110.

In operating environment 800, power supply 105 represents an AC voltage supply, and as such, includes terminals 204, 205, and 206, each representative of a phase of three-phase AC power. Switching circuitry 114 includes phase circuit 810, phase circuit 820, and phase circuit 830 in operating environment 800, each corresponding to a phase of the three-phase AC power. Load 120 includes terminals 207, 208, and 209, also each corresponding to a phase of the three-phase AC power.

More particularly, terminals 204, 205, and 206 are phase terminals of power supply 105 each corresponding to one phase of three-phase AC power produced by power supply 105. Particularly, terminal 204 corresponds to a first phase of the three-phase AC power, terminal 205 corresponds to a second phase of the three-phase AC power 120-degrees out-of-phase relative to the first phase, and terminal 206 corresponds to a third phase of the three-phase AC power 120-degrees out-of-phase relative to the first and second phases. Similarly, terminals 207, 208, and 209 are phase terminals of load 120 each corresponding to a respective one of the three-phases of AC power produced by power supply 105.

The AC power is provided from the phase terminals of power supply 105 to corresponding phase terminals of load 120 via respective phase circuits of switching circuitry 114. More specifically, terminals 204 and 207 are coupled to a first phase circuit 810, and as such, power is provided from terminal 204 to terminal 207 via phase circuit 810. Terminals 205 and 208 are coupled to a second phase circuit 830, and as such, power is provided from terminal 205 to terminal 208 via phase circuit 830. Terminals 206 and 209 are coupled to a third phase circuit 850, and as such, power is provided from terminal 206 to terminal 209 via phase circuit 850.

Phase circuits 810, 830, and 850 each include multiple switches and current clamping circuits. More specifically, phase circuit 810 includes switch 211, switch 215, current clamping circuit 220, and current clamping circuit 224, phase circuit 830 includes switch 231, switch 235, current clamping circuit 240, and current clamping circuit 244, and phase circuit 850 includes switch 251, switch 255, current clamping circuit 260, and current clamping circuit 264.

In various embodiments, switches 211, 215, 231, 235, 251, and 255 are representative of solid-state switches that may be controlled by processing circuitry 112 to turn off and on, or in other words, transition between open and closed states, respectively. For example, switches 211, 215, 231, 235, 251, and 255 are transistors controllable by signals provided by processing circuitry 112. In operating environment 800, switches 211 and 215 are controlled together by processing circuitry 112, switches 231 and 235 are controlled together by processing circuitry 112, and switches 251 and 255 are controlled together by processing circuitry 112. Examples of the transistors include metal-oxide semiconductor field-effect transistors (MOSFETs), bipolar junction transistors (BJTs), junction field-effect transistors (JFETs), insulated-gate bipolar transistors (IGBTs), or the like, as well as combinations and variations thereof. In such embodiments, the transistors may each include a first current path terminal (e.g., a drain), a second current path terminal (e.g., a source), and a control terminal (e.g., a gate). In some embodiments, the transistors may additionally include a body terminal.

In various embodiments, current clamping circuits 220, 224, 240, 244, 260, and 264 are representative of circuits that include various components capable of providing a path for current flow for dissipation thereof in the event of an overload condition (e.g., a short circuit). More specifically, current clamping circuit 220 can provide a path for current flow in the direction from power supply 105 to load 120 to bypass switch 211, current clamping circuit 224 can provide a path for current flow in the direction from load 120 to power supply 105 to bypass switch 215, current clamping circuit 240 can provide a path for current flow in the direction from power supply 105 to load 120 to bypass switch 231, current clamping circuit 244 can provide a path for current flow in the direction from load 120 to power supply 105 to bypass switch 235, current clamping circuit 260 can provide a path for current flow in the direction from power supply 105 to load 120 to bypass switch 251, and current clamping circuit 264 can provide a path for current flow in the direction from load 120 to power supply 105 to bypass switch 255. Due to the configuration of the components of the current clamping circuits, current flow is prevented from flowing the direction opposite the direction described above through the current clamping circuits.

Referring more specifically to the topology of phase circuit 810, switch 211 includes a first terminal coupled to terminal 204 of power supply 105, a second terminal coupled to a first terminal of switch 215, and a third terminal coupled to processing circuitry 112. Switch 211 also includes a body diode 213 including an anode terminal coupled to the second terminal of switch 211 and a cathode terminal coupled to the first terminal of switch 211. Switch 215 includes the first terminal coupled to switch 211, a second terminal coupled to terminal 207 of load 120, and a third terminal coupled to the third terminal of switch 211 such that the third terminals of switches 211 and 215 are coupled together at processing circuitry 112 and fed the same signals from processing circuitry 112. Switch 215 also includes a body diode 217 including an anode terminal coupled to the first terminal of switch 215 and a cathode terminal coupled to the second terminal of switch 215. Current clamping circuit 220 includes an input terminal coupled to terminal 204 and to the first terminal of switch 211, and an output terminal coupled to the second terminal of switch 211 and the first terminal of switch 215. Current clamping circuit 224 includes an input terminal coupled to terminal 207 of load 120 and to the second terminal of switch 215, and an output terminal coupled to the second terminal of switch 211 and the first terminal of switch 215.

Current clamping circuit 220 includes capacitor 221 and thyristor 222. Capacitor 221 includes a first terminal (the same as the input terminal of current clamping circuit 220) coupled to the first terminal of switch 211 and to terminal 204 of power supply 105, and a second terminal coupled to an anode terminal of thyristor 222. Thyristor 222 includes the anode terminal, a cathode terminal (the same as the output terminal of current clamping circuit 220) coupled to the second terminal of switch 211 and to the first terminal of switch 215, and a third terminal coupled to processing circuitry 112.

Current clamping circuit 224 includes capacitor 225 and thyristor 226. Capacitor 225 includes a first terminal (the same as the input terminal of current clamping circuit 220) coupled to the first terminal of switch 215 and to terminal 207 of load 120, and a second terminal coupled to an anode terminal of thyristor 226. Thyristor 226 includes the anode terminal, a cathode terminal (the same as the output terminal of current clamping circuit 224) coupled to the second terminal of switch 211 and to the first terminal of switch 215, and a third terminal coupled to processing circuitry 112.

Referring next to the topology of phase circuit 830, switch 231 includes a first terminal coupled to terminal 205 of power supply 105, a second terminal coupled to a first terminal of switch 235, and a third terminal coupled to processing circuitry 112. Switch 231 also includes a body diode 233 including an anode terminal coupled to the second terminal of switch 231 and a cathode terminal coupled to the first terminal of switch 231. Switch 235 includes the first terminal coupled to switch 231, a second terminal coupled to terminal 208 of load 120, and a third terminal coupled to the third terminal of switch 231 such that the third terminals of switches 231 and 235 are coupled together at processing circuitry 112 and fed the same signals from processing circuitry 112. Switch 235 also includes a body diode 237 including an anode terminal coupled to the first terminal of switch 235 and a cathode terminal coupled to the second terminal of switch 235. Current clamping circuit 240 includes an input terminal coupled to terminal 205 and to the first terminal of switch 231, and an output terminal coupled to the second terminal of switch 231 and the first terminal of switch 235. Current clamping circuit 244 includes an input terminal coupled to terminal 208 of load 120 and to the second terminal of switch 235, and an output terminal coupled to the second terminal of switch 231 and the first terminal of switch 235.

Current clamping circuit 240 includes capacitor 241 and thyristor 242. Capacitor 241 includes a first terminal (the same as the input terminal of current clamping circuit 240) coupled to the first terminal of switch 231 and to terminal 205 of power supply 105, and a second terminal coupled to an anode terminal of thyristor 242. Thyristor 242 includes the anode terminal, a cathode terminal (the same as the output terminal of current clamping circuit 240) coupled to the second terminal of switch 231 and to the first terminal of switch 235, and a third terminal coupled to processing circuitry 112.

Current clamping circuit 244 includes capacitor 245 and thyristor 246. Capacitor 245 includes a first terminal (the same as the input terminal of current clamping circuit 240) coupled to the first terminal of switch 235 and to terminal 208 of load 120, and a second terminal coupled to an anode terminal of thyristor 246. Thyristor 246 includes the anode terminal, a cathode terminal (the same as the output terminal of current clamping circuit 244) coupled to the second terminal of switch 231 and to the first terminal of switch 235, and a third terminal coupled to processing circuitry 112.

Referring next to the topology of phase circuit 850, switch 251 includes a first terminal coupled to terminal 206 of power supply 105, a second terminal coupled to a first terminal of switch 255, and a third terminal coupled to processing circuitry 112. Switch 251 also includes a body diode 253 including an anode terminal coupled to the second terminal of switch 251 and a cathode terminal coupled to the first terminal of switch 251. Switch 255 includes the first terminal coupled to switch 251, a second terminal coupled to terminal 209 of load 120, and a third terminal coupled to the third terminal of switch 251 such that the third terminals of switches 251 and 255 are coupled together at processing circuitry 112 and fed the same signals from processing circuitry 112. Switch 255 also includes a body diode 257 including an anode terminal coupled to the first terminal of switch 255 and a cathode terminal coupled to the second terminal of switch 255. Current clamping circuit 260 includes an input terminal coupled to terminal 206 and to the first terminal of switch 251, and an output terminal coupled to the second terminal of switch 251 and the first terminal of switch 255. Current clamping circuit 264 includes an input terminal coupled to terminal 209 of load 120 and to the second terminal of switch 255, and an output terminal coupled to the second terminal of switch 251 and the first terminal of switch 255.

Current clamping circuit 260 includes capacitor 261 and thyristor 262. Capacitor 261 includes a first terminal (the same as the input terminal of current clamping circuit 260) coupled to the first terminal of switch 261 and to terminal 206 of power supply 105, and a second terminal coupled to an anode terminal of thyristor 262. Thyristor 262 includes the anode terminal, a cathode terminal (the same as the output terminal of current clamping circuit 260) coupled to the second terminal of switch 251 and to the first terminal of switch 255, and a third terminal coupled to processing circuitry 112.

Current clamping circuit 264 includes capacitor 265 and thyristor 266. Capacitor 265 includes a first terminal (the same as the input terminal of current clamping circuit 260) coupled to the first terminal of switch 255 and to terminal 209 of load 120, and a second terminal coupled to an anode terminal of thyristor 266. Thyristor 266 includes the anode terminal, a cathode terminal (the same as the output terminal of current clamping circuit 264) coupled to the second terminal of switch 251 and to the first terminal of switch 255, and a third terminal coupled to processing circuitry 112.

In operation, in an on mode of circuit breaker 110, processing circuitry 112 provides signals to switches 211 and 215, switches 231 and 235, and switches 251 and 255 to turn the switches on allowing current flow from respective terminals of power supply 105 to corresponding respective terminals of load 120. Processing circuitry 112 may also provide signals to thyristors 222, 226, 242, 246, 262, and 266 to gate the thyristors, preventing current through current clamping circuits 220, 224, 240, 244, 260, and 264, respectively.

While current flows through phase circuits 810, 830, and 850 from power supply 105 to load 120 based on the signals provided to the elements of phase circuits 810, 830, and 850, processing circuitry 112 monitors the current at terminals 207, 208, and 209 of load 120. To do so, circuit breaker 110 includes one or more current sensors, among other types of sensors, coupled to outputs of switching circuitry 114.

If processing circuitry 112 determines the amount of current (e.g., magnitude, amplitude) is below a threshold current indicative of an overload or fault condition, processing circuitry 112 provides the same signals to the switches and thyristors of switching circuitry 114 to continue allowing current flow from power supply 105 to load 120. If processing circuitry 112 determines the amount of current exceeds the threshold current, processing circuitry 112 identifies the polarity of the current and provides signals to the switches and thyristors to control paths for the current flow based on the polarity.

The following discussion applies to current having a polarity indicative of current flow from power supply 105 to load 120. With respect to phase circuit 810, processing circuitry 112 provides signals to switch 211, switch 215, and thyristor 222 of phase circuit 810 to turn switches 211 and 215 off and turn thyristor 222 on, allowing current flow from terminal 204 of power supply 105 to terminal 207 of load 120 through current clamping circuit 220 and body diode 217, bypassing switches 211 and 215. With respect to phase circuit 830, processing circuitry 112 provides signals to switch 231, switch 235, and thyristor 242 of phase circuit 830 to turn switches 231 and 235 off and turn thyristor 242 on, allowing current flow from terminal 205 of power supply 105 to terminal 208 of load 120 through current clamping circuit 240 and body diode 237, bypassing switches 231 and 235. With respect to phase circuit 850, processing circuitry 112 provides signals to switch 251, switch 255, and thyristor 262 of phase circuit 850 to turn switches 251 and 255 off and turn thyristor 262 on, allowing current flow from terminal 206 of power supply 105 to terminal 209 of load 120 through current clamping circuit 260 and body diode 257, bypassing switches 251 and 255. Additionally, processing circuitry 112 may provide signals to thyristor 226 to keep current clamping circuit 224 off, to thyristor 246 to keep current clamping circuit 244 off, and to thyristor 266 to keep current clamping circuit 264 off. Based on the polarity of the current and the configurations of the phase circuits, the current within switching circuitry 114 dissipates and eventually falls below the threshold current for safe shut-down of circuit breaker 110. Once processing circuitry 112 determines that the current within each phase circuit falls to zero Amps, processing circuitry can provide signals to thyristors 222, 242, and 262 to turn the thyristors off and gate current clamping circuits 220, 240, and 260, respectively. Upon resolution of the fault condition, processing circuitry 112 can provide signals to switching circuitry 114 to turn circuit breaker 110 back on under normal operating conditions.

The following discussion applies to current having a polarity indicative of current flow from load 120 to power supply 105. With respect to phase circuit 810, processing circuitry 112 provides signals to switch 211, switch 215, and thyristor 226 of phase circuit 810 to turn switches 211 and 215 off and turn thyristor 226 on, allowing current flow from terminal 207 of load to terminal 204 of power supply 105 through current clamping circuit 224 and diode 213, bypassing switches 211 and 215. With respect to phase circuit 830, processing circuitry 112 provides signals to switch 231, switch 235, and thyristor 246 of phase circuit 830 to turn switches 231 and 235 off and turn thyristor 246 on, allowing current flow from terminal 208 of load 120 to terminal 205 of power supply 105 through current clamping circuit 244 and diode 233, bypassing switches 231 and 235. With respect to phase circuit 850, processing circuitry 112 provides signals to switch 251, switch 255, and thyristor 266 of phase circuit 850 to turn switches 251 and 255 off and turn thyristor 266 on, allowing current flow from terminal 209 of load 120 to terminal 206 of power supply 105 through current clamping circuit 264 and diode 253, bypassing switches 251 and 255. Additionally, processing circuitry 112 may provide signals to thyristor 222 to keep current clamping circuit 220 off, to thyristor 242 to keep current clamping circuit 240 off, and to thyristor 262 to keep current clamping circuit 262 off. Based on the polarity of the current and the configurations of the phase circuits, the current within switching circuitry 114 dissipates and eventually falls below the threshold current for safe shut-down of circuit breaker 110. Once processing circuitry 112 determines that the current within each phase circuit falls to zero Amps, processing circuitry 112 can provide signals to thyristors 226, 246, and 266 to turn the thyristors off and gate current clamping circuits 224, 244, and 264, respectively. Upon resolution of the fault condition, processing circuitry 112 can provide signals to switching circuitry 114 to turn circuit breaker 110 back on under normal operating conditions.

In various embodiments, with current flowing in either direction, processing circuitry 112 may turn the current clamping circuits on before turning the switches off. In this way, processing circuitry 112 provides an alternative current path for the current to and from power supply 105 and load 120 to help minimize the risk to the switches upon breaking the current flow resulting in a transient voltage.

In some embodiments, other sequences of voltages and leakage current flow may be contemplated. In some embodiments, additional, fewer, or different components may be included in switching circuitry 114, and in particular, in the current clamping circuits thereof. For example, instead of a capacitor-thyristor combination, the current clamping circuits may include a solid-state switch, a capacitor and diode coupled in series, or other current source components. Other types of diodes, thyristors, resistors, or other current sourcing or impeding devices, as well as combinations and variations thereof, may be contemplated.

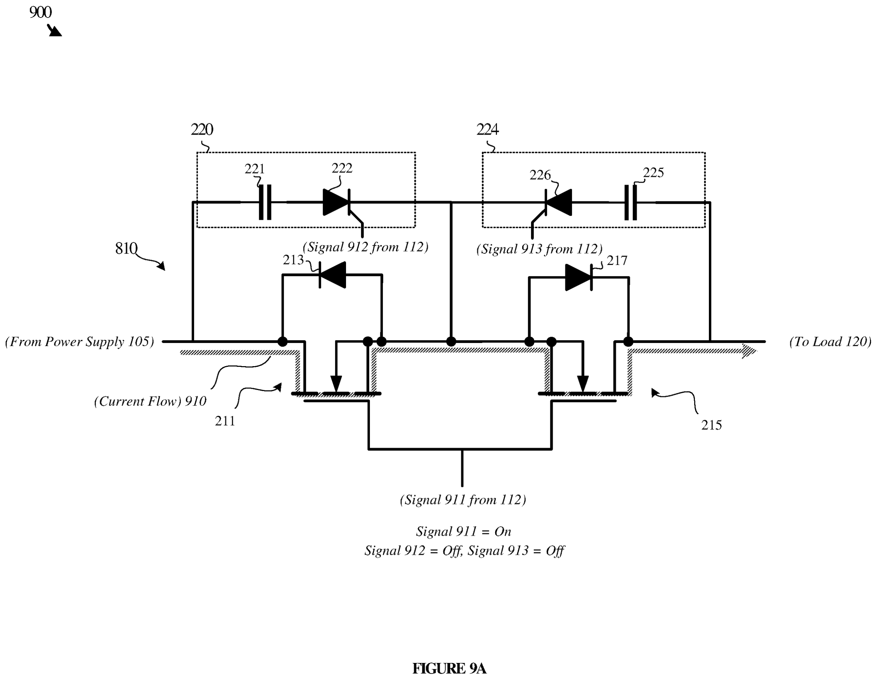

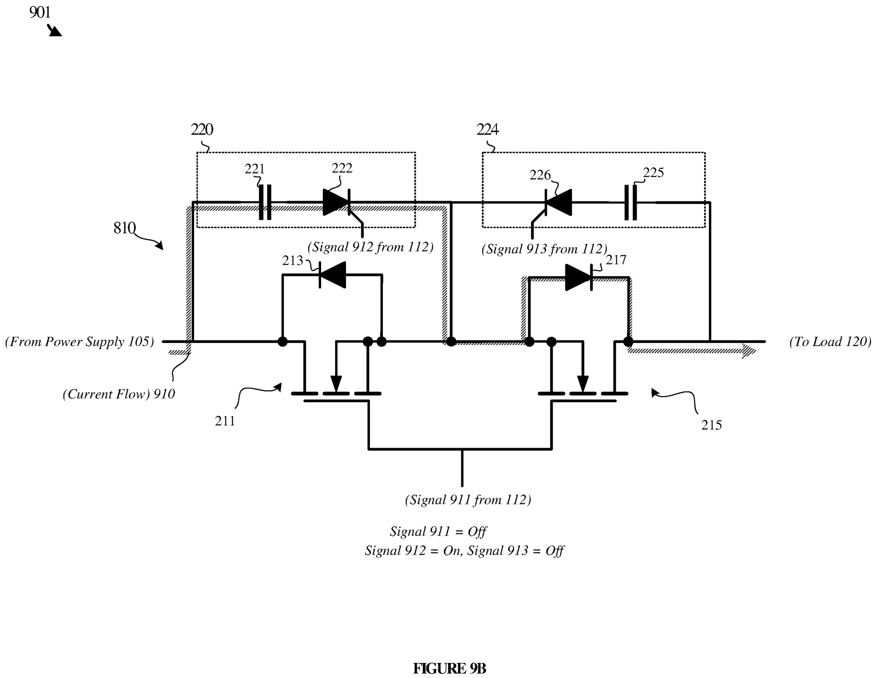

**Figures 9A** **and** **9B** illustrate example aspects of switching circuitry of a circuit breaker and resulting current flow through the elements of the switching circuitry during operation in accordance with some embodiments of the present technology. Figure 9A includes aspect 900, which includes phase circuit 810 of switching circuitry 114 of operating environment 800. Figure 9B includes aspect 901, which also includes phase circuit 810.

Referring generally to phase circuit 810 shown in Figures 9A and 9B, phase circuit 810 is representative of circuitry capable of operating in various modes to allow or restrict current flow from power supply 105 to load 120. In various embodiments where power supply 105 includes an AC power source, phase circuit 810 is one of three sub-circuits of switching circuitry 114 that can provide power of a single phase of three-phase AC power generated by power supply 105. Phase circuit 810 includes switch 211, diode 213, current clamping circuit 220, switch 215, diode 217, and current clamping circuit 224. Current clamping circuit 220 includes capacitor 221 and thyristor 222, and current clamping circuit 224 includes capacitor 225 and thyristor 226. Other sub-circuits of switching circuitry 114 as shown in operating environment 800, phase circuits 830 and 850, are not shown in Figures 9A and 9B for the sake of simplicity.

Referring first to aspect 900 of Figure 9A, aspect 900 shows a first mode of operation of circuit breaker 110 corresponding to an on mode in which current flow 910 travels from power supply 105 to load 120 via phase circuit 810. In the on mode, processing circuitry 112 provides signals 911, 912, and 913 to control terminals of switches 211 and 215, thyristor 222, and thyristor 225 of phase circuit 810, respectively. Signal 911 includes an indication to turn on, signal 912 includes an indication to turn off, and signal 913 includes an indication to turn off. Accordingly, switches 211 and 215 turn on, while current clamping circuits 220 and 224 are gated, and thus, current flow 910 travels from power supply 105 to load 120 via a path through current path terminals of switches 211 and 215.

Referring next to aspect 901 of Figure 9B, aspect 901 shows a second mode of operation of circuit breaker 110 corresponding to a tripped mode in which current produced by a transient voltage in response to a fault condition is broken within phase circuit 810. In this mode and based on the direction of current flow 910 from power supply 105 to load 120, processing circuitry 112 provides signals 911, 912, and 913 to control terminals of switches 211 and 215, thyristor 222, and thyristor 225 of phase circuit 810, respectively, in which signal 911 includes an indication to turn off, signal 912 includes an indication to turn on, and signal 913 includes an indication to turn off. Accordingly, switches 211 and 215 turn off, current clamping circuit 220 turns on, and current clamping circuit 224 turns (or remains) off. Based on the signals, current flow 910 travels in the direction from power supply 105 to load 120 via a path through current clamping circuit 220 and diode 217 bypassing switches 211 and 215.

After the amount of current flow 910 falls below a threshold current and reaches zero amps, processing circuitry 112 may provide signal 912 to thyristor 222 having an indication to turn off. Upon receiving signal 912 with such an indication, thyristor 222 turns off and gates current flow through current clamping circuit 220 from load 120 to power supply 105 based on the configuration of thyristor 222.

Additionally, processing circuitry 112 can perform switching operations with each of the phase circuits to dissipate current flow in the direction from load 120 to power supply 105. For example, processing circuitry 112 provides signals 911, 912, and 913 having values such that current flow in the direction from load 120 to power supply 105 travels through current clamping circuit 224 and diode 213, bypassing switches 211 and 215.

While other phase circuits are not shown in Figures 9A and 9B, processing circuitry 112 can control current flow through the other phase circuits in a similar manner, which may help dissipate current generated from a voltage transient and break such current through the use of one or more of the current clamping circuits of switching circuitry 114.

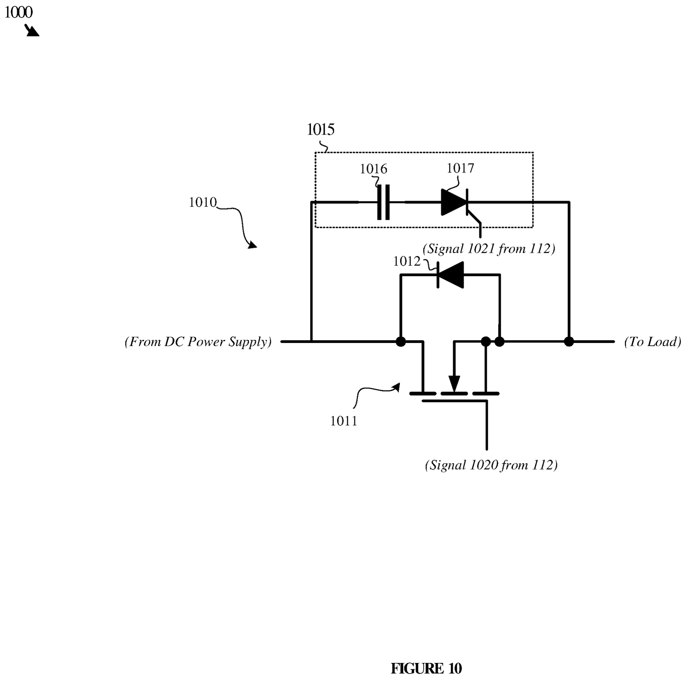

**Figure 10** illustrates an example operating environment in accordance with some embodiments of the present technology. Figure 10 shows operating environment 1000, which includes switching circuitry 1010.

In various embodiments, switching circuitry 1010 is representative of various mechanical, electrical, and/or electromechanical elements capable of interfacing with a direct current (DC) power supply to receive power, with processing circuitry (e.g., processing circuitry 112) to receive signals that control operations of the elements of switching circuitry 1010, and with a load (e.g., load 120) to provide power to the load at various times. Switching circuitry 1010 includes switch 1011, diode 1012, and current clamping circuit 1015.

Switch 1011 may be representative of a solid-state switch (e.g., a transistor), such as a metal-oxide semiconductor field-effect transistor (MOSFET), a bipolar junction transistor (BJT), a junction field-effect transistor (JFET), an insulated-gate bipolar transistor (IGBT), or the like, as well as combinations and variations thereof. Switch 1011 includes a first current path terminal (e.g., a drain), a second current path terminal (e.g., a source), and a control terminal (e.g., a gate). In some embodiments, switch 1011 also includes a body terminal.

Current clamping circuit 1015 may be representative of a circuit capable of providing an alternative path for current flow other than through switch 1011. For example, current clamping circuit 1015 includes capacitor 1016 and thyristor 1017 (e.g., a silicon-controlled rectifier (SCR)). In some embodiments, current clamping circuit 1015 may additionally, or alternatively, include solid-state switches, diodes, and other discrete components, as well as combinations and variations thereof.

With respect to the topology of switching circuitry 1010, the first current path terminal of switch 1011 is coupled to a terminal of the DC power supply, the second current path terminal is coupled to the load, and the control terminal is coupled to processing circuitry 1012. Diode 1012 includes an anode terminal coupled to the second current path terminal of switch 1011, and a cathode terminal coupled to the first current path terminal of switch 1011. Capacitor 1016 includes a first terminal coupled to the first current path terminal of switch 1011 and to the DC power supply, and a second terminal coupled to an anode terminal of thyristor 1017. Thyristor 1017 includes the anode terminal, a cathode terminal coupled to the second current path terminal of switch 1011 and to the load, and a control terminal coupled to processing circuitry 112.

In various embodiments, switch 1011 and thyristor 1017 are controlled by processing circuitry 112 to control current flow through the circuit breaker. More specifically, processing circuitry 112 provides signals to control terminals of switch 1011 and thyristor 1017 to control the operational states of the components (e.g., open state (i.e., off), closed state (i.e., on)).

Processing circuitry 112 may be configured to provide the signals based on an amount of current detected at the load. Under normal operating conditions, such as when the current at the load is below a threshold current, processing circuitry 112 provides signal 1020 to switch 1011 to turn on, and signal 1021 to thyristor 1017 to turn off, thus allowing current flow from the DC power supply to the load via switch 1011. Upon detection of a fault condition (e.g., a short circuit), such as when processing circuitry 112 detects that the amount of current at the load exceeds the threshold current, processing circuitry 112 provides signal 1020 to switch 1011 to turn off, and provides signal 1021 to thyristor 1017 to turn on, thus allowing current flow to bypass switch 1011 and instead travel through current clamping circuit 1015 preventing an overload of voltage at switch 1011, which may damage switch 1011.

**Figure 11** illustrates computing system 1101 to perform solid-state switching processes according to an implementation of the present technology. Computing system 1101 is representative of any system or collection of systems with which the various operational architectures, processes, scenarios, and sequences disclosed herein for device health collection and configuration may be employed. Computing system 1101 may be implemented as a single apparatus, system, or device or may be implemented in a distributed manner as multiple apparatuses, systems, or devices. Computing system 1101 includes, but is not limited to, processing system 1102, storage system 1103, software 1105, communication interface system 1107, and user interface system 1109 (optional). Processing system 1102 is operatively coupled with storage system 1103, communication interface system 1107, and user interface system 1109. Computing system 1101 may be representative of a cloud computing device, distributed computing device, or the like.

Processing system 1102 loads and executes software 1105 from storage system 1103. Software 1105 includes and implements switching process 1106, which is representative of any of the switching operations, voltage monitoring, current monitoring, current polarity detection, transistor gating, thyristor gating, and other processes discussed with respect to the preceding Figures. When executed by processing system 1102 to provide switching functions, software 1105 directs processing system 1102 to operate as described herein for at least the various processes, operational scenarios, and sequences discussed in the foregoing implementations. Computing system 1101 may optionally include additional devices, features, or functionality not discussed for purposes of brevity.

Referring still to Figure 11, processing system 1102 may comprise a microprocessor and other circuitry that retrieves and executes software 1105 from storage system 1103. Processing system 1102 may be implemented within a single processing device but may also be distributed across multiple processing devices or sub-systems that cooperate in executing program instructions. Examples of processing system 1102 include general purpose central processing units, graphical processing units, application specific processors, and logic devices, as well as any other type of processing device, combinations, or variations thereof.

Storage system 1103 may comprise any computer readable storage media readable by processing system 1102 and capable of storing software 1105. Storage system 1103 may include volatile and nonvolatile, removable and non-removable media implemented in any method or technology for storage of information, such as computer readable instructions, data structures, program modules, or other data. Examples of storage media include random access memory, read only memory, magnetic disks, optical disks, optical media, flash memory, virtual memory and non-virtual memory, magnetic cassettes, magnetic tape, magnetic disk storage or other magnetic storage devices, or any other suitable storage media. In no case is the computer readable storage media a propagated signal.

In addition to computer readable storage media, in some implementations storage system 1103 may also include computer readable communication media over which at least some of software 1105 may be communicated internally or externally. Storage system 1103 may be implemented as a single storage device but may also be implemented across multiple storage devices or sub-systems co-located or distributed relative to each other. Storage system 1103 may comprise additional elements, such as a controller, capable of communicating with processing system 1102 or possibly other systems.

Software 1105 (including switching process 1106) may be implemented in program instructions and among other functions may, when executed by processing system 1102, direct processing system 1102 to operate as described with respect to the various operational scenarios, sequences, and processes illustrated herein. For example, software 1105 may include program instructions for implementing a switching process as described herein.

In particular, the program instructions may include various components or modules that cooperate or otherwise interact to carry out the various processes and operational scenarios described herein. The various components or modules may be embodied in compiled or interpreted instructions, or in some other variation or combination of instructions. The various components or modules may be executed in a synchronous or asynchronous manner, serially or in parallel, in a single threaded environment or multi-threaded, or in accordance with any other suitable execution paradigm, variation, or combination thereof. Software 1105 may include additional processes, programs, or components, such as operating system software, virtualization software, or other application software. Software 1105 may also comprise firmware or some other form of machine-readable processing instructions executable by processing system 1102.

In general, software 1105 may, when loaded into processing system 1102 and executed, transform a suitable apparatus, system, or device (of which computing system 1101 is representative) overall from a general-purpose computing system into a special-purpose computing system customized to provide soft-start motor control instantiation thereof as described herein. Indeed, encoding software 1105 on storage system 1103 may transform the physical structure of storage system 1103. The specific transformation of the physical structure may depend on various factors in different implementations of this description. Examples of such factors may include, but are not limited to, the technology used to implement the storage media of storage system 1103 and whether the computer-storage media are characterized as primary or secondary storage, as well as other factors.

For example, if the computer readable storage media are implemented as semiconductor-based memory, software 1105 may transform the physical state of the semiconductor memory when the program instructions are encoded therein, such as by transforming the state of transistors, capacitors, or other discrete circuit elements constituting the semiconductor memory. A similar transformation may occur with respect to magnetic or optical media. Other transformations of physical media are possible without departing from the scope of the present description, with the foregoing examples provided only to facilitate the present discussion.

Communication interface system 1107 may include communication connections and devices that allow for communication with other computing systems (not shown) over communication networks (not shown). Examples of connections and devices that together allow for inter-system communication may include network interface cards, antennas, power amplifiers, radiofrequency circuitry, transceivers, and other communication circuitry. The connections and devices may communicate over communication media to exchange communications with other computing systems or networks of systems, such as metal, glass, air, or any other suitable communication media. The aforementioned media, connections, and devices are well known and need not be discussed at length here.

Communication between computing system 1101 and other computing systems (not shown), may occur over a communication network or networks and in accordance with various communication protocols, combinations of protocols, or variations thereof. Examples include intranets, internets, the Internet, local area networks, wide area networks, wireless networks, wired networks, virtual networks, software defined networks, data center buses and backplanes, or any other type of network, combination of networks, or variation thereof. The aforementioned communication networks and protocols are well known and need not be discussed at length here.

Unless the context clearly requires otherwise, throughout the description and the claims, the words "comprise," "comprising," and the like are to be construed in an inclusive sense, as opposed to an exclusive or exhaustive sense; that is to say, in the sense of "including, but not limited to." As used herein, the terms "connected," "coupled," or any variant thereof means any connection or coupling, either direct or indirect, between two or more elements; the coupling or connection between the elements can be physical, logical, or a combination thereof. Additionally, the words "herein," "above," "below," and words of similar import, when used in this application, refer to this application as a whole and not to any particular portions of this application. Where the context permits, words in the above Detailed Description using the singular or plural number may also include the plural or singular number respectively. The word "or," in reference to a list of two or more items, covers all of the following interpretations of the word: any of the items in the list, all of the items in the list, and any combination of the items in the list.

While specific examples for the technology are described above for illustrative purposes, various equivalent modifications are possible within the scope of the technology, as those skilled in the relevant art will recognize. For example, while processes or blocks are presented in a given order, alternative implementations may perform routines having steps, or employ systems having blocks, in a different order, and some processes or blocks may be deleted, moved, added, subdivided, combined, and/or modified to provide alternative or sub combinations. Each of these processes or blocks may be implemented in a variety of different ways. Also, while processes or blocks are at times shown as being performed in series, these processes or blocks may instead be performed or implemented in parallel or may be performed at different times. Further any specific numbers noted herein are only examples: alternative implementations may employ differing values or ranges.

These and other changes can be made to the technology in light of the above Detailed Description. While the above description describes certain examples of the technology, and describes the best mode contemplated, no matter how detailed the above appears in text, the technology can be practiced in many ways. Details of the system may vary considerably in its specific implementation, while still being encompassed by the technology disclosed herein. As noted above, particular terminology used when describing certain features or aspects of the technology should not be taken to imply that the terminology is being redefined herein to be restricted to any specific characteristics, features, or aspects of the technology with which that terminology is associated. In general, the terms used in the following claims should not be construed to limit the technology to the specific examples disclosed in the specification, unless the above Detailed Description section explicitly defines such terms. Accordingly, the actual scope of the technology encompasses not only the disclosed examples, but also all equivalent ways of practicing or implementing the technology under the claims.

To reduce the number of claims, certain aspects of the technology are presented below in certain claim forms, but the applicant contemplates the various aspects of the technology in any number of claim forms. For example, while only one aspect of the technology is recited as a computer-readable medium claim, other aspects may likewise be embodied as a computer-readable medium claim, or in other forms, such as being embodied in a means-plus-function claim. Any claims intended to be treated under 35 U.S.C. § 112(f) will begin with the words "means for" but use of the term "for" in any other context is not intended to invoke treatment under 35 U.S.C. § 112(f). Accordingly, the applicant reserves the right to pursue additional claims after filing this application to pursue such additional claim forms, in either this application or in a continuing application.

## Claims

1. A circuit breaker comprising:
processing circuitry; and
switching circuitry coupled to the processing circuitry and comprising:
a first switch including a first terminal coupled to an alternating current (AC) voltage supply, a second terminal, and a control terminal coupled to the processing circuitry;
a second switch including a first terminal coupled to the second terminal of the first switch, a second terminal coupled to a load, and a control terminal coupled to the processing circuitry;
a first current clamping circuit including an input terminal coupled to the AC voltage supply, a control terminal coupled to the processing circuitry, and an output terminal coupled to the first terminal of the second switch; and
a second current clamping circuit including an input terminal coupled to the load, a control terminal coupled to the processing circuitry, and an output terminal coupled to the second terminal of the first switch;
wherein the processing circuitry is configured to:
monitor the current at the load; and
provide gating signals to the control terminals of the first switch, the second switch, the first current clamping circuit, and the second current clamping circuit to control a path of current flow between the AC voltage supply and the load based at least in part on the current at the load.

2. The circuit breaker of claim 1, wherein:
the first current clamping circuit comprises:
a first capacitor having a first terminal coupled to the AC voltage supply, and a second terminal coupled to a first terminal of a first thyristor, and
the first thyristor having the first terminal, the control terminal coupled to the processing circuitry, and a second terminal coupled to the first terminal of the second switch; and
the second current clamping circuit comprises:
a second capacitor having a first terminal coupled to the load, and a second terminal coupled to a first terminal of a second thyristor, and
the second thyristor having the first terminal, the control terminal coupled to the processing circuitry, and a second terminal coupled to the second terminal of the first switch.

3. The circuit breaker of claim 2, wherein to provide the gating signals to the control terminals of the first switch, the second switch, the first current clamping circuit, and the second current clamping circuit, the processing circuitry is configured to:
responsive to determining that the current at the load has reached a threshold breaking current with a first polarity, transmit the gating signals to the control terminals of the first switch and the first thyristor of the first current clamping circuit to allow current flow from the AC voltage supply to the load through the first current clamping circuit and through the first and second terminals of the second switch, wherein the current flow bypasses the first switch via the first current clamping circuit; and
responsive to determining that the current at the load has fallen below a threshold current, transmit the gating signals to the control terminal of the first thyristor of the first current clamping circuit to gate the current flow through the first current clamping circuit.

4. The circuit breaker of claim 3, wherein to provide the gating signals to the control terminals of the first switch, the second switch, the first current clamping circuit, and the second current clamping circuit, the processing circuitry is further configured to transmit the gating signals to the control terminal of the first thyristor of the first current clamping circuit prior to transmitting the gating signals to the control terminal of the first switch.

5. The circuit breaker of claim 3, wherein to provide the gating signals to the control terminals of the first switch, the second switch, the first current clamping circuit, and the second current clamping circuit, the processing circuitry is configured to:
responsive to determining that the current at the load has reached a threshold breaking current with a second polarity, transmit the gating signals to the control terminals of the second switch and the second thyristor of the second current clamping circuit to allow current flow from the load to the AC voltage supply through the second current clamping circuit and through the first and second terminals of the first switch, wherein the current flow bypasses the second switch via the second current clamping circuit; and
responsive to determining that the current at the load has fallen below a threshold current, transmit the gating signals to the control terminal of the first thyristor of the first current clamping circuit to gate the current flow through the first current clamping circuit.

6. The circuit breaker of claim 5, at least one of:
wherein to provide the gating signals to the control terminals of the first switch, the second switch, the first current clamping circuit, and the second current clamping circuit, the processing circuitry is further configured to, responsive to determining that the current at the load has fallen below a second threshold current, transmit the gating signals to the control terminals of the first and second switches preventing the current flow from the AC voltage supply to the load; and
wherein the threshold breaking current corresponds to an overload condition of the circuit breaker.

7. The circuit breaker of one of claims 1 to 6, at least one of:
wherein the first and second switches comprise one of metal-oxide semiconductor field-effect transistors (MOSFETs), insulated gate bipolar transistors (IGBTs), or junction field effect transistors (JFETs); and
wherein the first and second thyristors comprise silicon-controlled recitifiers.

8. The circuit breaker of one of claims 1 to 7, wherein the switching circuitry further comprises:
a third switch including a first terminal coupled to the AC voltage supply, a second terminal, and a control terminal coupled to the processing circuitry;
a fourth switch including a first terminal coupled to the second terminal of the third switch, a second terminal coupled to the load, and a control terminal coupled to the processing circuitry;
a third current clamping circuit including an input terminal coupled to the AC voltage supply, a control terminal coupled to the processing circuitry, and an output terminal coupled to the first terminal of the fourth switch;
a fourth current clamping circuit including an input terminal coupled to the load, a control terminal coupled to the processing circuitry, and an output terminal coupled to the second terminal of the third switch;
a fifth switch including a first terminal coupled to the AC voltage supply, a second terminal, and a control terminal coupled to the processing circuitry;
a sixth switch including a first terminal coupled to the second terminal of the fifth switch, a second terminal coupled to the load, and a control terminal coupled to the processing circuitry;
a fifth current clamping circuit including an input terminal coupled to the AC voltage supply, a control terminal coupled to the processing circuitry, and an output terminal coupled to the first terminal of the sixth switch;
a sixth current clamping circuit including an input terminal coupled to the load, a control terminal coupled to the processing circuitry, and an output terminal coupled to the second terminal of the fifth switch.

9. The circuit breaker of claim 8, wherein:
the AC voltage supply comprises three terminals corresponding to phases of three-phase AC power generated by the AC voltage supply;
the load comprises three terminals corresponding to the phases of the three-phase AC power;
the first terminal of the first switch is coupled to a first terminal of the three terminals of the AC voltage supply associated with a first phase of the three-phase AC power;
the second terminal of the second switch is coupled to a first terminal of the three terminals of the load associated with the first phase of the three-phase AC power;
the first terminal of the third switch is coupled to a second terminal of the three terminals of the AC voltage supply associated with a second phase of the three-phase AC power;
the second terminal of the fourth switch is coupled to a second terminal of the three inputs of the load associated with the second phase of the three-phase AC power;
the first terminal of the fifth switch is coupled to a third terminal of the three terminals of the AC voltage supply associated with a third phase of the three-phase AC power; and
the second terminal of the sixth switch is coupled to a third terminal of the three terminals of the AC motor associated with the third phase of the three-phase AC power.

10. A method comprising:
monitoring a current of a load coupled to a circuit breaker, wherein the circuit breaker includes:
a first switch including a first terminal coupled to an alternating current (AC) voltage supply, a second terminal, and a control terminal coupled to the processing circuitry;
a second switch including a first terminal coupled to the second terminal of the first switch, a second terminal coupled to the load, and a control terminal coupled to the processing circuitry;
a first current clamping circuit including an input terminal coupled to the AC voltage supply, a control terminal coupled to the processing circuitry, and an output terminal coupled to the first terminal of the second switch; and
a second current clamping circuit including an input terminal coupled to the load, a control terminal coupled to the processing circuitry, and an output terminal coupled to the second terminal of the first switch;
responsive to determining that the current at the load has reached a threshold breaking current, transmitting gating signals to the control terminals of the first switch, the second switch, the first current clamping circuit, and the second current clamping circuit to control a path of current flow between the AC voltage supply and the load based at least in part on the current at the load.

11. The method of claim 10, wherein:
the first current clamping circuit comprises:
a first capacitor having a first terminal coupled to the AC voltage supply, and a second terminal coupled to a first terminal of a first thyristor, and
the first thyristor having the first terminal, the control terminal coupled to the processing circuitry, and a second terminal coupled to the first terminal of the second switch; and
the second current clamping circuit comprises:
a second capacitor having a first terminal coupled to the load, and a second terminal coupled to a first terminal of a second thyristor, and
the second thyristor having the first terminal, the control terminal coupled to the processing circuitry, and a second terminal coupled to the second terminal of the first switch.

12. The method of claim 11, wherein transmitting the gating signals to the control terminals of the first switch, the second switch, the first current clamping circuit, and the second current clamping circuit comprises:
responsive to determining that the current at the load has reached a threshold breaking current with a first polarity, transmitting the gating signals to the control terminals of the first switch and the first thyristor of the first current clamping circuit to allow current flow from the AC voltage supply to the load through the first current clamping circuit and through the first and second terminals of the second switch, wherein the current flow bypasses the first switch via the first current clamping circuit; and
responsive to determining that the current at the load has fallen below a threshold current, transmitting the gating signals to the control terminal of the first thyristor of the first current clamping circuit to gate the current flow through the first current clamping circuit.

13. The method of claim 12, at least one of:
wherein transmitting the gating signals to the control terminals of the first switch, the second switch, the first current clamping circuit, and the second current clamping circuit comprises transmitting the gating signals to the control terminal of the first thyristor of the first current clamping circuit prior to transmitting the gating signals to the control terminal of the first switch; and
wherein transmitting the gating signals to the control terminals of the first switch, the second switch, the first current clamping circuit, and the second current clamping circuit comprises:
responsive to determining that the current at the load has reached a threshold breaking current with a second polarity, transmitting the gating signals to the control terminals of the second switch and the second thyristor of the second current clamping circuit to allow current flow from the load to the AC voltage supply through the second current clamping circuit and through the first and second terminals of the first switch, wherein the current flow bypasses the second switch via the second current clamping circuit; and
responsive to determining that the current at the load has fallen below a threshold current, transmitting the gating signals to the control terminal of the first thyristor of the first current clamping circuit to gate the current flow through the first current clamping circuit, preferably wherein transmitting the gating signals to the control terminals of the first switch, the second switch, the first current clamping circuit, and the second current clamping circuit comprises, responsive to determining that the current at the load has fallen below a second threshold current, transmitting the gating signals to the control terminals of the first and second switches preventing the current flow from the AC voltage supply to the load.

14. A circuit breaker comprising:
processing circuitry; and
switching circuitry coupled to the processing circuitry and comprising:
a first switch including a first terminal coupled to an alternating current (AC) voltage supply, a second terminal, and a control terminal coupled to the processing circuitry;
a first thyristor including an anode terminal coupled to the second terminal of the first switch, and a cathode terminal coupled to the first terminal of the first switch;
a second switch including a first terminal coupled to the second terminal of the first switch, a second terminal coupled to a load, and a control terminal coupled to the processing circuitry;
a second thyristor including an anode terminal coupled to the second terminal of the second switch, and a cathode terminal coupled to the first terminal of the second switch;
a first current clamping circuit including an input terminal coupled to the AC voltage supply, a control terminal coupled to the processing circuitry, and an output terminal coupled to the first terminal of the second switch; and
a second current clamping circuit including an input terminal coupled to the load, a control terminal coupled to the processing circuitry, and an output terminal coupled to the second terminal of the first switch;
wherein the processing circuitry is configured to:
monitor the current at the load; and
provide gating signals to the control terminals of the first switch, the second switch, the first current clamping circuit, and the second current clamping circuit to control a path of current flow between the AC voltage supply and the load based at least in part on the current at the load.

15. The circuit breaker of claim 14, wherein to provide the gating signals to the control terminals of the first switch, the second switch, the first current clamping circuit, and the second current clamping circuit, the processing circuitry is configured to:
responsive to determining that the current at the load has reached a threshold breaking current with a first polarity, transmit the gating signals to the control terminals of the first switch and the first thyristor of the first current clamping circuit to allow current flow from the AC voltage supply to the load through the first current clamping circuit and through the second thyristor, wherein the current flow bypasses the first switch via the first current clamping circuit and the second switch via the second thyristor; and
responsive to determining that the current at the load has fallen below a threshold current, transmit the gating signals to the control terminal of the first thyristor of the first current clamping circuit to gate the current flow through the first current clamping circuit,
preferably wherein to provide the gating signals to the control terminals of the first switch, the second switch, the first current clamping circuit, and the second current clamping circuit, the processing circuitry is configured to:
responsive to determining that the current at the load has reached a threshold breaking current with a second polarity, transmit the gating signals to the control terminals of the second switch and the second thyristor of the second current clamping circuit to allow current flow from the load to the AC voltage supply through the second current clamping circuit and through the first thyristor, wherein the current flow bypasses the second switch via the second current clamping circuit and the first switch via the first thyristor; and
responsive to determining that the current at the load has fallen below a threshold current, transmit the gating signals to the control terminal of the first thyristor of the first current clamping circuit to gate the current flow through the first current clamping circuit.
